(19) Europäisches Patentamt
European Patent Office
Office européen des brevets

(11) **EP 3 277 062 B1**

(12) **EUROPEAN PATENT SPECIFICATION**

(45) Date of publication and mention
of the grant of the patent:
**17.07.2019 Bulletin 2019/29**

(51) Int Cl.:
*H05K 1/02* *(2006.01)*      *H05K 1/09* *(2006.01)*
*H05K 3/24* *(2006.01)*

(21) Application number: **17177352.6**

(22) Date of filing: **22.06.2017**

(54) **WIRING BOARD AND ELECTRONIC APPARATUS**

LEITERPLATTE UND ELEKTRONISCHE VORRICHTUNG

CARTE DE CÂBLAGE ET APPAREIL ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.07.2016 JP 2016146518**

(43) Date of publication of application:
**31.01.2018 Bulletin 2018/05**

(73) Proprietor: **Fujitsu Limited
Kawasaki-shi, Kanagawa 211-8588 (JP)**

(72) Inventors:
• **Matsumura, Takayoshi
Kawasaki-shi, Kanagawa 211-8588 (JP)**
• **Baba, Shunji
Kawasaki-shi, Kanagawa 211-8588 (JP)**
• **Kanda, Takashi
Kawasaki-shi, Kanagawa 211-8588 (JP)**
• **Ozaki, Noritsugu
Kawasaki-shi, Kanagawa 211-8588 (JP)**
• **Kira, Hidehiko
Kawasaki-shi, Kanagawa 211-8588 (JP)**

(74) Representative: **Hoffmann Eitle
Patent- und Rechtsanwälte PartmbB
Arabellastraße 30
81925 München (DE)**

(56) References cited:
**EP-A1- 2 845 726          EP-A1- 2 924 695
US-A1- 2013 303 873     US-A1- 2014 085 837
US-A1- 2015 123 137**

**Description**

FIELD

The embodiments discussed herein relate to a wiring board and an electronic apparatus.

BACKGROUND

Flexible wiring boards, which are also referred to as flexible circuit boards or the like, have conventionally been known. Among these known substrates, there is a flexible wiring board including a base made of an elastic material such as an elastomer. On this base, corrugated wirings that are extendable, contractible, or deformable in one direction (for example, in a longitudinal direction of the base) are formed by using metal foils.

For example, see Japanese Laid-open Patent Publication No. 2013-187308

When the flexible wiring board is deformed and is then extended as a result, a crack or a fracture could be caused in a wiring on the base. Such a crack in a wiring could change the resistance of the wiring and characteristics of the wiring board. If such a wiring board, whose characteristics could change when the wiring board is extended, is used for an electronic apparatus, the electronic apparatus could fail to operate stably.

EP 2,924,695 A1 discloses a flexible conductive member including an elastic substrate and a plurality of conductive layers arranged on a surface of the substrate in at least one of a stacked manner and a parallel manner. The conductive layers include: a first conductive layer including a highly conductive material that contains an elastomer and a conductive agent and has a volume resistivity of $5 \times 10^{-2}$ Ω.cm or less in an unextended condition; and a second conductive layer including a highly extensible conductive material that has a volume resistivity in an unextended condition larger than the volume resistivity of the highly conductive material in an unextended condition, contains an elastomer and a conductive agent, and has a change in volume resistivity at an elongation of 50% relative to an unextended condition of 10 times or less.

US 2014/0085837 A1 discloses a flexible conduction trace including a flexible line; and a plurality of conductive particles arranged in the form of pillars within the flexible line.

US 2013/0303873 A1 discloses a hopper having a passage through which a medicine can be passed downward. A part of a lower portion of the hopper is a deformable portion having flexibility, and the deformable portion is deformable so as to open and close the passage. According to this configuration, the deformable portion that is a part of the hopper is deformed to open and close the passage. Thus, there is no portion such as an opening and closing plate on which the medicine remains, thereby preventing a gap in which the medicine remains from being formed in the hopper, and preventing the medicine from easily remaining in the hopper.

SUMMARY

The present invention provides a wiring board in accordance with claim 1.

The present invention also provides an electronic apparatus in accordance with claim 10.

BRIEF DESCRIPTION OF DRAWINGS

FIGS. 1A and 1B illustrate a wiring board according to a first example;
FIG. 2 illustrates an extended wiring board according to the first example;
FIGS. 3A and 3B illustrate a wiring board according to a second example;
FIGS. 4A and 4B illustrate a wiring board according to a third example
;FIGS. 5A and 5B illustrate a wiring board according to a first illustrative example;
FIGS. 6A and 6B illustrate extensibility of the wiring board according to the third example;
FIGS. 7A and 7B illustrate extensibility of the wiring board according to the first illustrative example;
FIGS. 8A and 8B illustrate resistance of the wiring board according to the third example before a crack is caused;
FIGS. 9A and 9B illustrate resistance of the wiring board according to the third example after a crack is caused;
FIGS. 10A and 10B illustrate resistance of the wiring board according to the first illustrative example before a crack is caused;
FIGS. 11A and 11B illustrate resistance of the wiring board according to the first illustrative example after a crack is caused;
FIGS. 12A to 12C illustrate the extension direction of a wiring of a wiring board according to a fourth example;
FIGS. 13A to 13C illustrate the extension direction of a wiring of a wiring board according to a first variation of the first illustrative example;

FIGS. 14A and 14B illustrate a main extension axis of the wiring boards according to the first illustrative example and the first variation thereof, respectively;

FIG. 15 illustrates a bent wiring board according to the first illustrative example or the first variation thereof;

FIGS. 16A and 16B illustrate structure examples of wiring boards according to second and third variations of the first illustrative example;

FIGS. 17A to 17D illustrate structure examples of a wiring of the wiring board according to the first illustrative example;

FIGS. 18A to 18C illustrate structure examples of a wiring of the wiring board according to the first illustrative example;

FIGS. 19A and 19B illustrate structure examples of a wiring of the wiring board according to the first illustrative example;

FIGS. 20A and 20B illustrate structure examples of wirings of wiring boards according fourth and fifth variations of the first illustrative example;

FIGS. 21A to 21C illustrate a structure example of a beacon according to a fifth example;FIG. 22 illustrates a structure example of a beacon according to a second illustrative example;

FIG. 23 illustrates a beacon according to a first variation of the second illustrative example;

FIG. 24 illustrates a beacon according to a second variation of the second illustrative example;

FIG. 25 illustrates a beacon according to a third variation of the second illustrative example;

FIGS. 26A and 26B illustrate examples of a conductor portion according to the invention;

FIG. 27 illustrates a wiring board according to an embodiment of the invention;

FIGS. 28A and 28B illustrate other examples of the conductor portion according to the invention;

FIGS. 29A and 29B illustrate other embodiments of the wiring board according to the invention; and

FIG. 30 illustrates an example of an electronic apparatus.

## DESCRIPTION OF EMBODIMENTS

First, a wiring board having extensibility will be described.

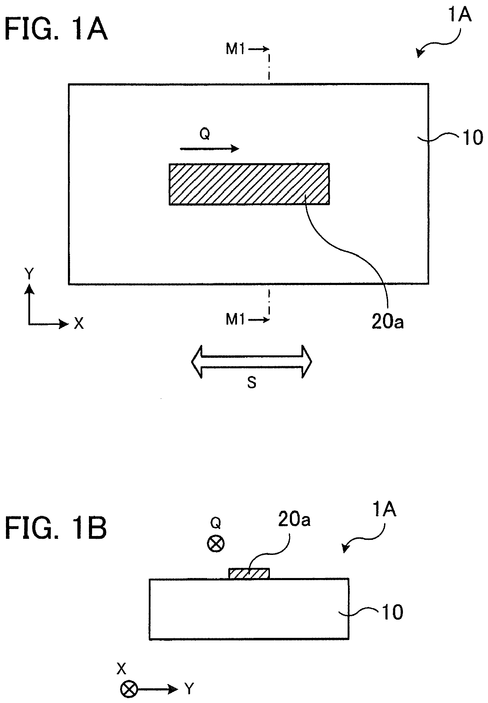

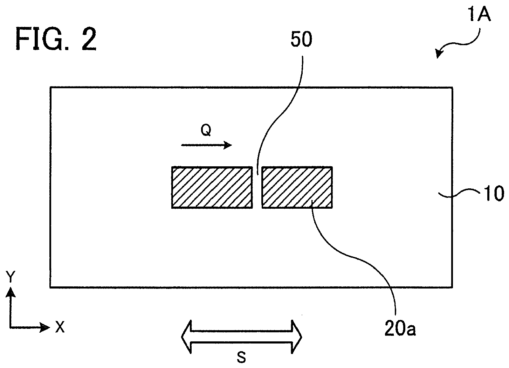

FIG. 1A to FIG. 2 illustrate a wiring board according to a first example. More specifically, FIG. 1A is a schematic plan view of a main portion of a wiring board according to a first example. FIG. 1B is a schematic sectional view taken along line M1-M1 in FIG. 1A. FIG. 2 is a schematic plan view of a main portion of an extended wiring board according to the first example.

This wiring board 1A illustrated in FIGS. 1A and 1B includes a base 10 having flexibility and extensibility and a wiring portion 20a formed on the base 10.

The base 10 is made of an elastic material (an elastomer) such as silicone rubber. For example, as illustrated in FIG. 1A, the base 10 is made of a material whose planar shape is rectangular or substantially rectangular. In addition, the wiring portion 20a is made of metal foil such as copper (Cu) foil having lower extensibility than that of the base 10. In FIGS. 1A and 1B, a single wiring portion 20a, which is formed on the base 10 and extends in a direction Q in parallel with a longitudinal direction X of the base 10, is illustrated as an example. The "extensibility" of an object represents how much the object is elastically extendable in a certain direction when pulled in that certain direction.

Because of the flexibility and extensibility of the base 10, the wiring board 1A is installable on a curved surface, for example. In addition, the wiring board 1A is deformable or extendable by external force. In such cases, the wiring board 1A is extended temporarily or continuously. FIG. 2 is a schematic plan view of the wiring board 1A extended along its main extension axis S in parallel with the longitudinal direction X of the base 10. The wiring board 1A is mainly extended along the main extension axis S, depending on the installation site or usage environment thereof.

When the wiring board 1A is extended along the main extension axis S, the force extending the wiring board 1A is also applied to the wiring portion 20a on the base 10. The wiring portion 20a made of metal foil has higher elasticity and lower extensibility than those of the base 10 made of an elastomer. Thus, the wiring portion 20a could hinder the extension of the base 10 in the longitudinal direction X in parallel with the main extension axis S. In addition, because of the relatively low extensibility of the wiring portion 20a, as illustrated in FIG. 2, a crack 50 such as a fracture that runs in a lateral direction Y of the base 10 could be caused in the wiring portion 20a when the wiring board 1A is extended in the longitudinal direction X of the base 10.

For example, the base 10 of the wiring board 1A is made of an elastomer having an elasticity of 20 MPa to 40 MPa and an extensibility of 200%. In contrast, the wiring portion 20a on the base 10 is made of Cu foil having an elasticity of 110 GPa to 128 GPa and an extensibility of 0.2%. When the wiring board 1A including the base 10 and wiring portion 20a made of the above materials is used, the wiring portion 20a could hinder the extension of the base 10 or the crack 50 could be caused in the wiring portion 20a.

This hindrance of the extension of the base 10 could limit the deformation amount, the installation site, or the usage environment of the wiring board 1A. In addition, the crack 50 in the wiring portion 20a could increase the resistance of the wiring board 1A or could break a current path on the base 10.

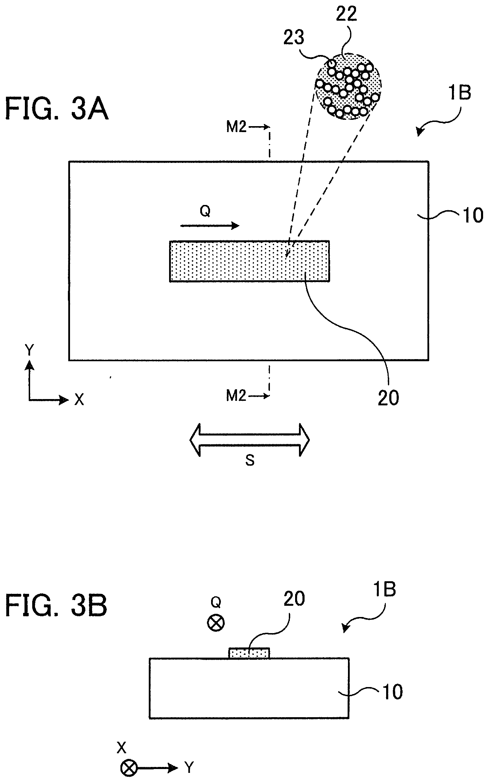

FIGS. 3A and 3B illustrate a wiring board according to a second example. More specifically, FIG. 3A is a schematic plan view of a main portion of a wiring board according to a second example, and FIG. 3B is a schematic sectional view taken along line M2-M2 in FIG. 3A.

This wiring board 1B according to the second example illustrated in FIGS. 3A and 3B also includes a base 10 having extensibility and a wiring portion 20 extending in a direction Q (a longitudinal direction X of the base 10) on the base 10. However, the wiring board 1B differs from the wiring board 1A according to the first example in that the wiring portion 20 is made of material having higher extensibility.

The wiring portion 20 is made of conductive paste. For example, the conductive paste is made by including conductive fillers such as silver (Ag) fillers in an insulating binder such as silicone rubber or epoxy resin. The wiring portion 20 is formed by printing the conductive paste on the base 10. As an example, FIG. 3A illustrates a partial enlargement of the wiring portion 20 including a binder 22 and fillers 23.

The wiring portion 20 made of the above conductive paste has extensibility. In the case of the wiring board 1B, since the wiring portion 20 on the base 10 made of an elastomer has extensibility, the extension of the base 10 in the longitudinal direction X thereof in parallel with the main extension axis S is less hindered, compared with the wiring board 1A including the wiring portion 20a made of metal foil on the base 10. In addition, since the wiring portion 20 has extensibility, even when the base 10 is extended in its longitudinal direction X in parallel with the main extension axis S, the chance of occurrence of a crack is lower.

However, the conductive paste serving as the wiring portion 20 is formed by including conductive fillers in an insulating binder, the wiring portion 20 has higher resistivity than that of the wiring portion 20a made of metal foil. When the wiring portion 20 made of conductive paste is formed to have a relatively thin film thickness that does not hinder the extension of the base 10, the wiring portion 20 has higher resistance than that of the wiring portion 20a made of metal foil. As a result, when a current flows from an upstream circuit (not illustrated) on one end of the wiring portion 20 to a downstream circuit (not illustrated) on the other end of the wiring portion 20 in the direction Q, a relatively large voltage drop could be caused. Namely, the downstream circuit could suffer from a lack of power and could not operate stably.

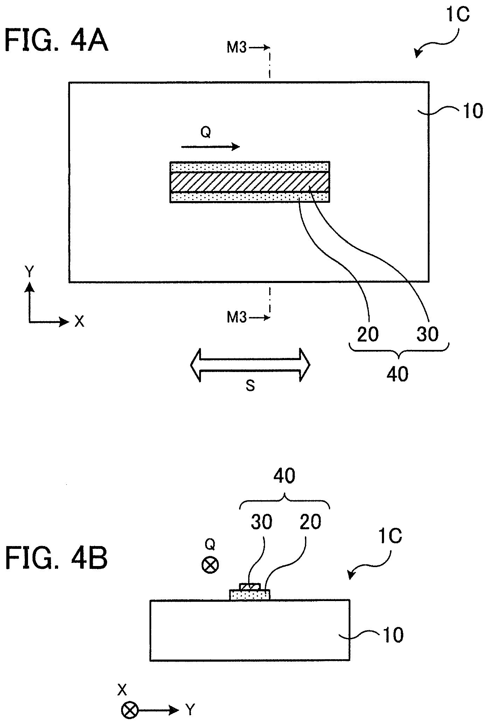

FIGS. 4A and 4B illustrate a wiring board according to a third example. More specifically, FIG. 4A is a schematic plan view of a main portion of a wiring board according to a third example, and FIG. 4B is a schematic sectional view taken along line M3-M3 in FIG. 4A.

This wiring board 1C according to the third example illustrated in FIGS. 4A and 4B also includes a base 10 having extensibility and a wiring portion 20 extending in a direction Q (a longitudinal direction X of the base 10) on the base 10. However, the wiring board 1C differs from the wiring board 1B according to the second example in that the wiring board 1C includes a conductor portion 30 on the wiring portion 20.

The wiring portion 20 of the wiring board 1C is made of conductive paste as described above. The conductor portion 30 is made of material having lower resistivity than that of the conductive paste used for the wiring portion 20. For example, the conductor portion 30 is made of metal foil such as Cu foil.

By forming the conductor portion 30 on the wiring portion 20, the conductor portion 30 having resistivity lower than that of the wiring portion 20 made of conductive paste, the resistance of a wiring 40, which is formed by the wiring portion 20 and the conductor portion 30, is reduced. The conductor portion 30 serves as an auxiliary pattern that helps the flow of electric charges that need to be transmitted through the wiring portion 20, which is a wiring pattern whose resistance is relatively high. By forming the conductor portion 30 on the wiring portion 20, the resistance of the wiring 40 is consequently reduced. Thus, the voltage drop that occurs when a current flows an upstream circuit (not illustrated) on one end of the wiring 40 to a downstream circuit (not illustrated) on the other end of the wiring 40 in the direction Q is reduced. In addition, a lack of the power of the downstream circuit caused by the voltage drop is reduced.

However, in the case of the wiring board 1C, when metal foil is used as the conductor portion 30 on the wiring portion 20, the conductor portion 30 could have the same problem with the above first example. Namely, when the wiring board 1C is extended in the longitudinal direction X of the base 10 in parallel with the main extension axis S, the conductor portion 30 having lower extensibility than that of the base 10 and of the wiring portion 20 could hinder the extension. Thus, for example, the deformation amount or the installation site of the wiring board 1C could be limited. In addition, a crack that runs in a lateral direction Y perpendicular to the extension of the base 10 in the longitudinal direction X in parallel with the main extension axis S could be caused in the conductor portion 30. As a result, the resistance of the wiring 40 could be increased.

In the case of the wiring 40 of the wiring board 1C, even when a crack is caused in the conductor portion 30, the wiring portion 20 thereunder serves as a current path. However, the wiring 40 exhibits different resistance, depending on whether a crack is caused in the conductor portion 30. Thus, since the level of the voltage drop accordingly varies, the power supplied to a downstream circuit through the wiring 40 could vary. When the wiring board 1C exhibits different characteristics depending on whether a crack is caused in the conductor portion 30, a downstream circuit could not stably operate.

In view of the above points, techniques will be described. The following techniques reduce the resistance of a wiring board, improve the extensibility of a wiring board along a main extension axis, and reduce the change of characteristics caused by extension of a wiring board along a main extension axis. First, a first illustrative example will be described.

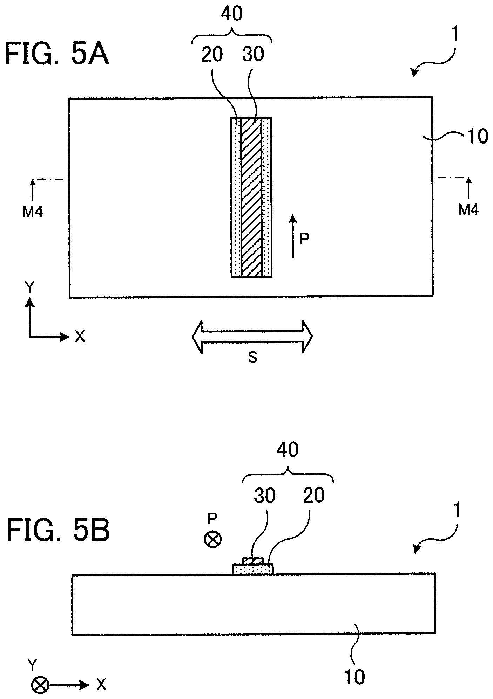

FIGS. 5A and 5B illustrate a wiring board according to a first illustrative example. More specifically, FIG. 5A is a schematic plan view of a main portion of a wiring board, and FIG. 5B is a schematic sectional view taken along line M4-M4 in FIG. 5A. This wiring board 1 illustrated in FIGS. 5A and 5B includes a base 10 having flexibility and extensibility, a wiring portion 20 (a wiring pattern) formed on the base 10, and a conductor portion 30 (an auxiliary conductor pattern) formed on the wiring portion 20. The "extensibility" of an object represents how much the object is elastically extendable in a certain direction when pulled in that certain direction.

The base 10 is made of an elastomer such as silicone rubber or urethane rubber. Alternatively, other than such an elastomer, the base 10 may be made of a fluorine, styrene, olefinic, ester, amide, vinyl chloride, or butadiene elastomer. For example, as illustrated in FIG. 5A, a material whose planar shape is rectangular or substantially rectangular is used as the base 10. A longitudinal direction X of the base 10 is in parallel with a main extension axis S of the wiring board 1. The wiring board 1 is mainly extended along the main extension axis S, depending on the installation site or usage environment thereof.

The wiring portion 20 is made of conductive paste made by including conductive fillers in an insulating binder. As the insulating binder, an elastomer such as silicone rubber or resin material such as epoxy resin is used, for example. As the conductive fillers, for example, any one of various metal particles such as Ag particles or Cu particles, materials obtained by coating organic particles with any one of various metal materials such as Ag or Cu, or carbon materials such as carbon nanotubes (CNTs) are used. The wiring portion 20 is formed by printing such conductive paste on the base 10. The wiring portion 20 has extensibility. The wiring portion 20 is extended in a direction P perpendicular to the longitudinal direction X of the base 10, which is in parallel with the main extension axis S of the wiring board 1. As illustrated in FIG. 5A, for example, the wiring portion 20 is extended in a lateral direction Y perpendicular to the longitudinal direction X.

The conductor portion 30 is made of material having lower resistivity than that of the wiring portion 20. For example, the conductor portion 30 is made of any one of various kinds of metal foil (including alloy foil) such as Cu foil, aluminum (Al) foil, nickel (Ni) foil, gold (Au) foil, Ag foil, tin (Sn) foil, or solder foil. The conductor portion 30 has lower extensibility than that of the wiring portion 20. In the same way as the wiring portion 20, the conductor portion 30 extends in the direction P on the wiring portion 20 that extends in the direction P in parallel with the lateral direction Y of the base 10.

The wiring portion 20 and the conductor portion 30 thereon form a wiring 40, which serves as at least a part of a current path of the wiring board 1. FIGS. 5A and 5B illustrate, as an example, a single wiring 40 (the wiring portion 20 and the conductor portion 30) extending in the direction P.

The wiring board 1 differs from the wiring board 1C including the wiring 40 extending in the direction Q in parallel with the main extension axis S as illustrated in FIGS. 4A and 4B in that the wiring 40 formed by the wiring portion 20 and the conductor portion 30 extends in the direction P perpendicular to the main extension axis S.

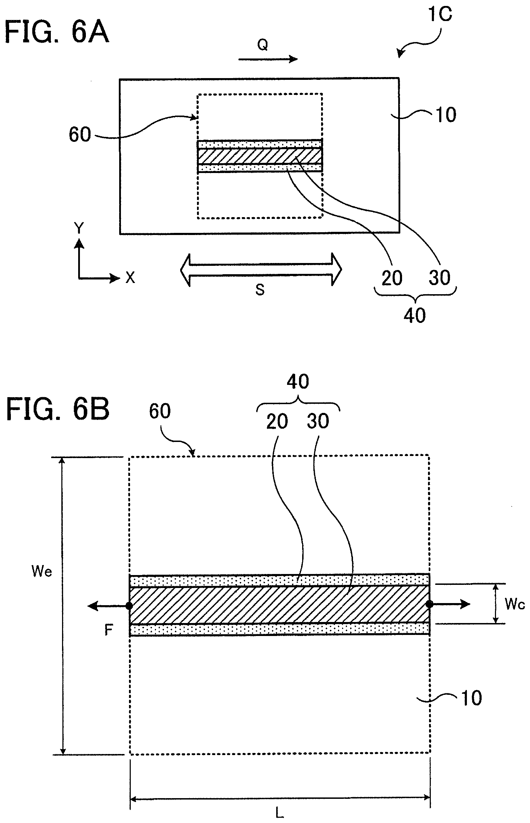

On the wiring board 1, the relatively highly resistive wiring portion 20 is formed first. Next, the conductor portion 30 having lower resistivity than that of the wiring portion 20 is formed on the wiring portion 20. In this way, the wiring 40 having low resistivity is formed. In addition, on the wiring board 1, the wiring 40 extends in the direction P perpendicular to the main extension axis S. Thus, compared with the case in which the wiring 40 extends in the direction in parallel with the main extension axis S, the extensibility of the base 10 is improved. In addition, since the wiring 40 on the wiring board 1 extends in the direction P perpendicular to the main extension axis S, the chance of occurrence of a crack when the wiring board 1 is extended along the main extension axis S is reduced, and the resistance increase by the extension is also reduced. Namely, change of the characteristics of the wiring board 1 is reduced. These points will be described with reference to FIGS. 6A to 11B.

FIGS. 6A to 7B illustrate extensibility of wiring boards.

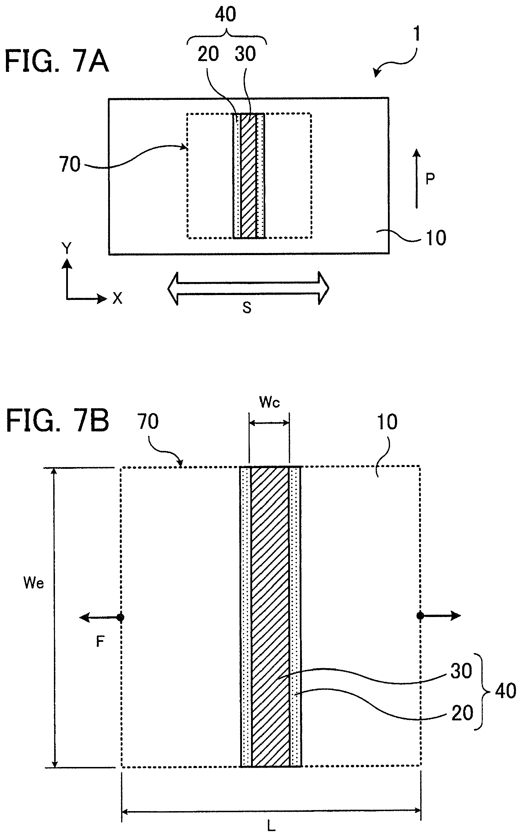

FIGS. 6A and 6B illustrate, for comparison, extensibility of the wiring board 1C according to the third example. FIGS. 7A and 7B illustrate extensibility of the wiring board 1 according to the first illustrative example. More specifically, FIG. 6A is a schematic plan view of a main portion of the wiring board 1C, and FIG. 6B is an enlarged view of a dotted line region (a wiring region) 60 in FIG. 6A. In addition, FIG. 7A is a schematic plan view of a main portion of the wiring board 1, and FIG. 7B is an enlarged view of a dotted line region (a wiring region) 70 in FIG. 7A.

Regarding the wiring board 1C illustrated in FIGS. 6A and 6B, an extension $\Delta L$ of the wiring region 60 by force F along the main extension axis S is expressed by the following expression (1), wherein L represents an initial length, Ee and Ae represent Young's modulus and a cross-sectional area of the base 10, and Ec and Ac represent Young's modulus and a cross-sectional area of the conductor portion 30. The cross-sectional areas Ae and Ac are the cross-sectional areas of the base 10 and the conductor portion 30, respectively, in the lateral direction Y.

$$\Delta L = FL/(EeAe + EcAc) \; ...(1)$$

Regarding the wiring board 1 illustrated in FIGS. 7A and 7B, an extension ΔL of the wiring region 70 by force F along the main extension axis S is expressed by the following expressions (2) and (3), wherein L represents an initial length, Ee and Ae represent Young's modulus and a cross-sectional area of the base 10, and Wc, Ec, and Ac represent a width, Young's modulus, and a cross-sectional area of the conductor portion 30. The cross-sectional areas Ae and Ac are the cross-sectional areas of the base 10 and the conductor portion 30, respectively, in the lateral direction Y.

$$\Delta L = FWc/(EeAe + EcAc) + F(L - Wc)/EeAt \ \ldots(2)$$

$$At = Ac + Ae \ \ldots(3)$$

The following description assumes that the base 10 in each of the wiring regions 60 and 70 has Young's modulus Ee of 40 MPa, a thickness Te of 2 mm, and a width We of 20 mm. The following description also assumes that the conductor portion 30 in each of the wiring regions 60 and 70 has Young's modulus Ec of 120 GPa, a thickness Tc of 0.05 mm, and a width Wc of 4 mm. In this case, the wiring region 70 of the wiring board 1 represents extensibility 12.8 times larger than that of the wiring region 60 of the wiring board 1C.

Extending the conductor portion 30 (the wiring 40) in the direction P perpendicular to the main extension axis S as illustrated on the wiring board 1 achieves higher extensibility than that achieved by extending the conductor portion 30 (the wiring 40) in the direction Q in parallel with the main extension axis S as illustrated on the wiring board 1C.

In addition, with the wiring board 1C including the conductor portion 30 extending in the direction Q in parallel with the main extension axis S, a crack is caused in the conductor portion 30 when a force of 5.2 kgf is applied. In contrast, with the wiring board 1 including the conductor portion 30 extending in the direction P perpendicular to the main extension axis S, a crack is not caused in the conductor portion 30 until a force of 24.8 kgf is applied. The conductor portion 30 of the wiring board 1 achieves resistance (load bearing) against tensile stress 4.7 times larger than that of the conductor portion 30 of the wiring board 1C.

The wiring board 1 including the conductor portion 30 (the wiring 40) extending in the direction P perpendicular to the main extension axis S is more advantageous in both extensibility and load bearing.

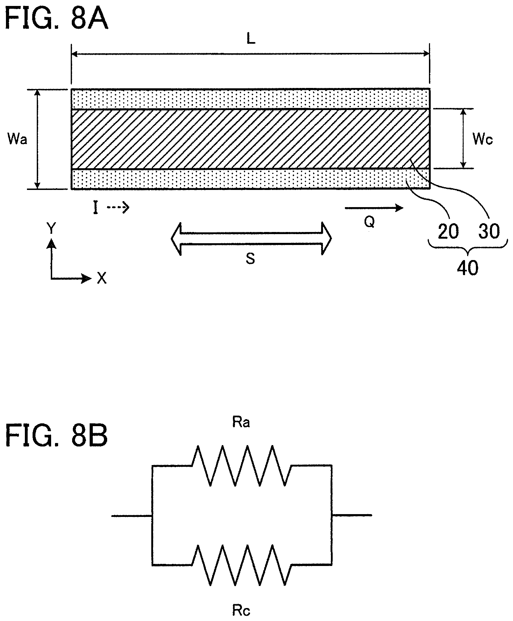

FIG. 8A to FIG. 11B illustrate resistances of wiring boards.

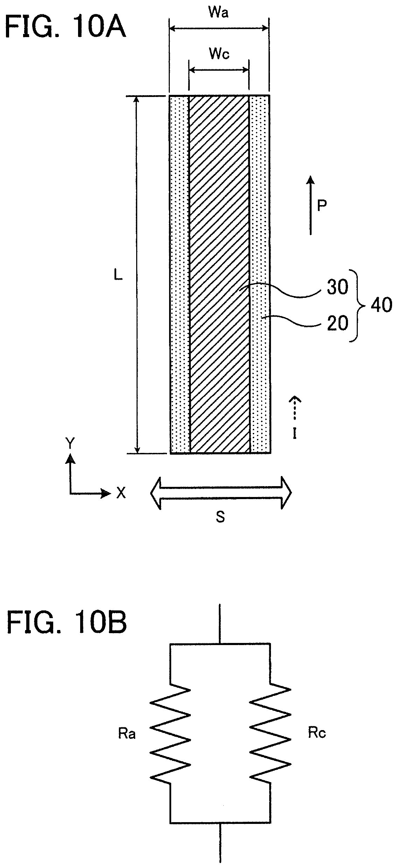

FIGS. 8A to 9B illustrate, for comparison, resistances of the wiring 40 of the wiring board 1C according to the third example before and after a crack is caused. FIGS. 10A to 11B illustrate resistances of the wiring 40 of the wiring board 1 according to the first illustrative example before and after a crack is caused. For comparison, first, the resistance of the wiring 40 extending in the direction Q in parallel with the main extension axis S before a crack is caused will be described with reference to FIGS. 8A and 8B.

FIG. 8A schematically illustrates the wiring 40 in the wiring region 60 (FIGS. 6A and 6B) of the wiring board 1C before a crack is caused. FIG. 8B illustrates an equivalent circuit of the wiring 40 in FIG. 8A.

An equivalent circuit of the wiring 40 as illustrated in FIG. 8A including the wiring portion 20 and the conductor portion 30 without a crack (the direction of a current I is indicated by a dotted arrow) is represented by a parallel circuit as illustrated in FIG. 8B. The parallel circuit is formed by a resistance Ra of the wiring portion 20 and a resistance Rc of the conductor portion 30.

The following description assumes that the wiring 40 (the wiring portion 20 and the conductor portion 30) has a length L, the wiring portion 20 has a thickness Ta, a width Wa, and a resistivity Ka, and the conductor portion 30 has a thickness Tc, a width Wc, and a resistivity Kc. Under these conditions, the resistance Ra of the wiring portion 20 and the resistance Rc of the conductor portion 30 are represented by the following expressions (4) and (5), respectively.

$$Ra = KaL/(TaWa) \ \ldots(4)$$

$$Rc = KcL/(TcWc) \ \ldots(5)$$

From the expressions (4) and (5), the resistance R(1/R = 1/Ra + 1/Rc) of the wiring 40 is expressed by the following expression (6).

$$R = KaKcL/(TaWaKc + TcWcKa) \ \ldots(6)$$

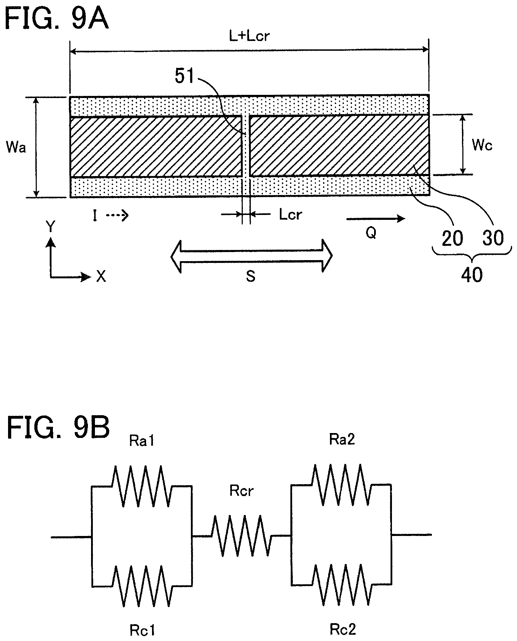

Next, the resistance of the wiring 40 extending in the direction Q in parallel with the main extension axis S after a crack is caused will be described with reference to FIGS. 9A and 9B.

FIG. 9A schematically illustrates the wiring 40 in the wiring region 60 (FIGS. 6A and 6B) of the wiring board 1C after a crack is caused. FIG. 9B illustrates an equivalent circuit of the wiring 40 in FIG. 9A.

When the wiring board 1C is extended along the main extension axis S, as illustrated in FIG. 9A, a crack 51 running in the direction P perpendicular to the direction Q could be caused in the conductor portion 30 on the wiring portion 20. The equivalent circuit of the wiring 40 (the direction of the current I is indicated by a dotted arrow) having the crack 51 is illustrated in FIG. 9B. The equivalent circuit includes a parallel circuit of a resistance Ra1 of the wiring portion 20 and a resistance Rc1 of the conductor portion 30 on one side of the crack 51. The equivalent circuit also includes a parallel circuit of a resistance Ra2 of the wiring portion 20 and a resistance Rc2 of the conductor portion 30 on the other side of the crack 51. These parallel circuits are connected to each other via a resistance Rcr of the wiring portion 20 corresponding to the crack 51.

The following description assumes that the wiring 40 (the wiring portion 20 and the conductor portion 30) has a length L and that the wiring portion 20 has a thickness Ta, a width Wa, and a resistivity Ka. The following description also assumes that the conductor portion 30 has a thickness Tc, a width Wc, and a resistivity Kc and that the crack 51 has a width Lcr. Under these conditions, the resistance R (R = (1/Ra1 + 1/Rc1) - 1 + (1/Ra2 + 1/Rc2) - 1 + Rcr) of the wiring 40 including the conductor portion 30 having the crack 51 is represented by the following expression (7).

$$R = KaKcL/(TaWaKc + TcWcKa) + KaLcr/TaWa \ldots (7)$$

From these expressions (7) and (6), it is seen that the resistance (expression (7)) of the wiring 40 including the conductor portion 30 having the crack 51 is higher than that of the wiring 40 (expression (6)) without the crack 51 by KaLcr/TaWa. Among the paths of the current I flowing from one end to the other end of the wiring 40, the path of the current flowing through the conductor portion 30 is divided by the crack 51 into the upstream and downstream sides. Thus, the resistance R of the wiring 40 is increased by the resistance Rcr of the wiring portion 20 at the point of the division.

Thus, since the crack 51 in the conductor portion 30 increases the resistance of the wiring 40, the characteristics of the wiring board 1C vary. With the wiring board 1C including the conductor portion 30 having the crack 51, the wiring 40 undergoes a larger voltage drop, compared with the wiring board 1C including the conductor portion 30 without the crack 51. As a result, since a downstream circuit connected to the wiring 40 receives an insufficient amount of power, the downstream circuit could not stably operate or fail to operate at all.

Next, the resistance of the wiring 40 extending in the direction P perpendicular to the main extension axis S before a crack is caused will be described with reference to FIGS. 10A and 10B.

FIG. 10A schematically illustrates the wiring 40 in the wiring region 70 (FIGS. 7A and 7B) of the wiring board 1 before a crack is caused. FIG. 10B illustrates an equivalent circuit of the wiring 40 in FIG. 10A.

An equivalent circuit of the wiring 40 as illustrated in FIG. 10A including the wiring portion 20 and the conductor portion 30 without a crack (the direction of a current I is indicated by a dotted arrow) is represented by a parallel circuit as illustrated in FIG. 10B. The parallel circuit is formed by a resistance Ra of the wiring portion 20 and a resistance Rc of the conductor portion 30. A resistance R (1/R = 1/Ra + 1/Rc) of the wiring 40 is expressed by the following expression (8), which is the same as the above expression (6).

$$R = KaKcL/(TaWaKc + TcWcKa) \ldots (8)$$

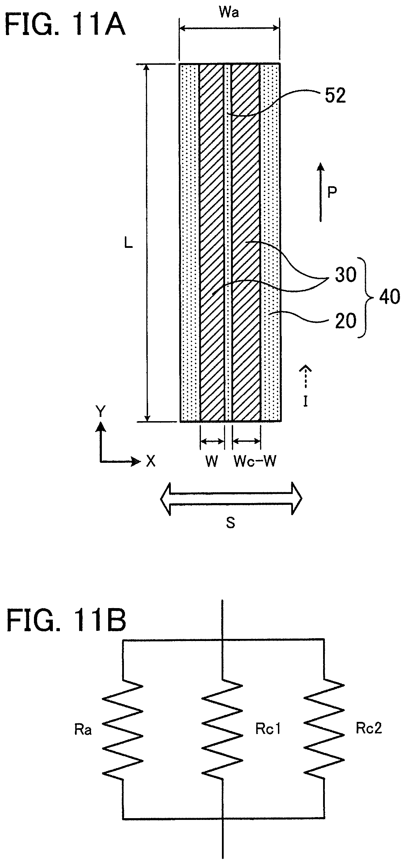

Next, the resistance of the wiring 40 extending in the direction P perpendicular to the main extension axis S after a crack is caused will be described with reference to FIGS. 11A and 11B.

FIG. 11A schematically illustrates the wiring 40 in the wiring region 70 (FIGS. 7A and 7B) of the wiring board 1 after a crack is caused. FIG. 11B illustrates an equivalent circuit of the wiring 40 in FIG. 11A.

When the wiring board 1 is extended along the main extension axis S, a crack 52 running in the direction P perpendicular to the main extension axis S could be caused in the conductor portion 30 on the wiring portion 20, as illustrated in FIG. 11A. The equivalent circuit of the wiring 40 (the direction of the current I is indicated by a dotted arrow) having the crack 52 is represented by a parallel circuit as illustrated in FIG. 11B. The parallel circuit is formed by a resistance Ra of the wiring portion 20, a resistance Rc1 of the conductor portion 30 on one side of the crack 52, and a resistance Rc2 of the conductor portion 30 on the other side of the crack 52.

The following description assumes that the wiring 40 (the wiring portion 20 and the conductor portion 30) has a length L and that the wiring portion 20 has a thickness Ta, a width Wa, and a resistivity Ka. The following description also assumes that the conductor portion 30 has a thickness Tc, a width Wc, and a resistivity Kc and that the conductor portion 30 on one side of the crack 52 has a width W. Under these conditions, the resistor Ra of the wiring portion 20, the resistor Rc1 of the conductor portion 30 on one side, and the resistor Rc2 of the conductor portion 30 on the other side are expressed by the following expressions (9) to (11), respectively.

$$Ra = KaL/(TaWa) \ ...(9)$$

$$Rc1 = KcL/(TcW) \ ...(10)$$

$$Rc2 = KcL/\{Tc(Wc - W)\} \ ...(11)$$

From these expressions (9) to (11), when the crack 52 is caused in the conductor portion 30 on the wiring portion 20 of the wiring 40 extending in the direction P perpendicular to the main extension axis S, the resistance R (1/R = 1/Ra + 1/Rc1 + 1/Rc2) of the wiring 40 is expressed by the following expression (12).

$$R = KaKcL/(TaWaKc + TcWcKa) \ ...(12)$$

This expression (12) is the same as the above expression (8). Namely, even when the crack 52 running in the direction P is caused in the conductor portion 30 on the wiring portion 20 of the wiring board 1, regardless of the value of the width W (or a width Wc - W) of the conductor portion 30 divided by the crack 52, the resistance R of the wiring 40 represents the same value as that before the crack 52 is caused. Among the paths of the current I flowing through from one end to the other end of the wiring 40, the path of the current flowing through the conductor portion 30 is not divided by the crack 52 into the upstream and downstream sides. Thus, whether the crack 52 is caused or not, the resistance R of the wiring 40 does not change. Therefore, the increase of the resistance is prevented.

In this way, even when the wiring 40 extending in the direction P perpendicular to the main extension axis S is extended along the main extension axis S and the crack 52 running in the direction P is thereby caused, the resistance of the wiring 40 is not increased, and the characteristics of the wiring board 1 are not changed. As a result, whether the crack 52 is caused or not, the voltage drop of the wiring 40 is prevented, and change of the amount of power supplied to the downstream circuit connected to the wiring 40 is prevented. Therefore, the downstream circuit is able to operate stably.

The wiring board 1 including the conductor portion 30 (the wiring 40) extending in the direction P perpendicular to the main extension axis S is more advantageous in that the characteristics (resistance) of the wiring board 1 are not changed even when a crack is caused.

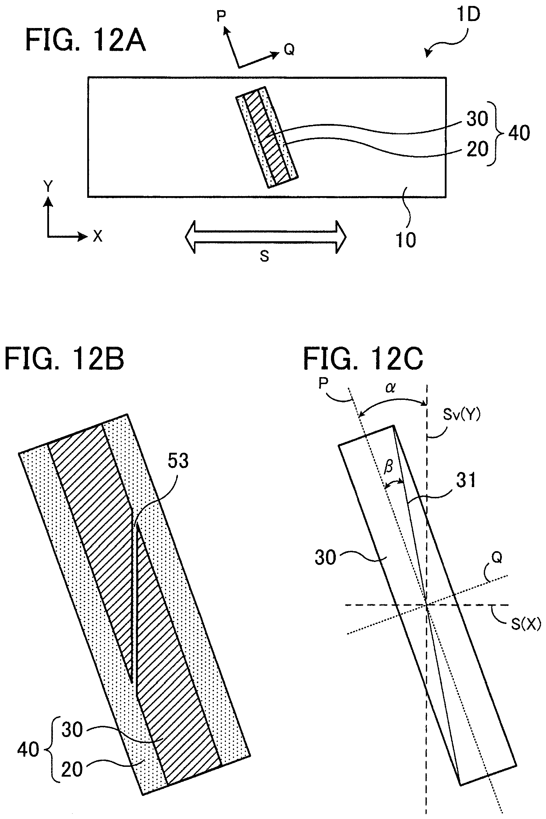

The above description has been made on the basis of an example in which the wiring 40 (the wiring portion 20 and the conductor portion 30) extends in the direction P perpendicular to the main extension axis S of the wiring board 1. However, the wiring 40 may be formed to extend in a direction other than the direction P perpendicular to the main extension axis S. This will be described with reference to FIGS. 12A to 13C.

FIGS. 12A to 13C illustrate the extension directions of wirings of wiring boards.

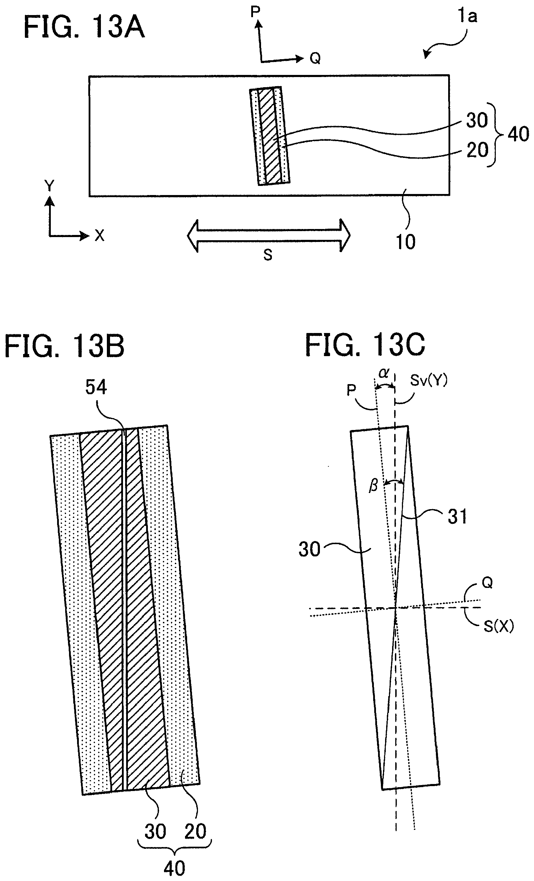

More specifically, FIG. 12A is a schematic plan view of a main portion of a wiring board according to a fourth example. FIG. 12B is a schematic plan view of a wiring of the wiring board in FIG. 12A, the wiring including a wiring portion and a conductor portion, which is formed on the wiring portion and in which a crack has been caused. FIG. 12C is a schematic plan view of the conductor portion of the wiring board in FIG. 12A. In addition, FIG. 13A is a schematic plan view of a main portion of a wiring board according to a first variation of the first illustrative example. FIG. 13B is a schematic plan view of a wiring of the wiring board in FIG. 13A, the wiring including a wiring portion and a conductor portion, which is formed on the wiring portion and in which a crack has been caused. FIG. 13C is a schematic plan view of the conductor portion of the wiring board in FIG. 13A.

For example, the following description assumes that the wiring board 1D as illustrated in FIG. 12A includes a base 10 and a wiring 40 thereon. The wiring 40 includes a wiring portion 20 extending in a direction P diagonally crossing a main extension axis S (a longitudinal direction X of the base 10) and a conductor portion 30 on the wiring portion 20.

As in the case of the wiring board 1D, when the direction P in which the wiring 40 extends has a certain angle or more with respect to a direction (a lateral direction Y of the base 10) perpendicular to the main extension axis S, if the wiring board 1D is extended along the main extension axis S, a crack 53 as illustrated in FIG. 12B running in the direction perpendicular to the main extension axis S is caused. As a result, the resistance of the wiring 40 increases. This is because the path of the current flowing through the conductor portion 30 from one end of the wiring 40 to the other end thereof is divided by the crack 53 into the upstream and downstream sides. Namely, the same situation as described with reference to FIGS. 9A and 9B arises.

In contrast, as illustrated in FIG. 13A, the direction P in which the wiring 40 of the wiring board 1a extends has the certain angle or less with respect to the direction (the lateral direction Y of the base 10) perpendicular to the main extension axis S. In this case, unlike the wiring board 1D, the increase of the resistance of the wiring 40 is prevented. This is because, even when the wiring board 1a is extended and a crack 54 as illustrated in FIG. 13B running in the direction perpendicular to the main extension axis S is caused in the conductor portion 30, the path of the current flowing through the conductor portion 30 from one end of the wiring 40 to the other end thereof is not divided by the crack 54 into the upstream and downstream sides. Namely, the same situation as described with reference to FIGS. 11A and 11B is maintained.

The following knowledge is obtained from these viewpoints.

Namely, as illustrated in FIG. 12C, when an angle $\alpha$ between a direction Sv (the lateral direction Y of the base 10) perpendicular to the main extension axis S (the longitudinal direction X of the base 10) and the direction P of the conductor portion 30 is larger than an angle $\beta$ between the direction P of the conductor portion 30 and a diagonal line 31, the resistance of the wiring 40 is increased by the crack 53.

In contrast, as illustrated in FIG. 13C, when the angle $\alpha$ between the direction Sv (the lateral direction Y of the base 10) perpendicular to the main extension axis S (the longitudinal direction X of the base 10) and the direction P of the conductor portion 30 is smaller than the angle $\beta$ between the direction P of the conductor portion 30 and the diagonal line 31, the resistance of the wiring 40 by the crack 54 is not increased.

When the longitudinal direction X of the base 10 is in parallel with the main extension axis S, the wiring 40 may be formed to extend in the direction P while satisfying the above relationship $\alpha < \beta$. In this way, even when the base 10 is extended along the main extension axis S, the increase of the resistance of the wiring 40 is effectively prevented.

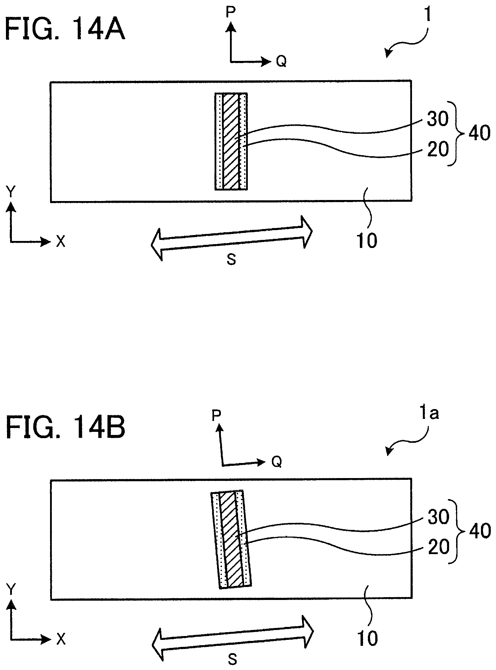

The wiring boards 1 and 1a have been described as examples, assuming that the longitudinal direction X of the base 10 is in parallel with the main extension axis S. However, the main extension axis S may diagonally cross the longitudinal direction X of the base 10. This will be described with reference to FIGS. 14A and 14B.

FIGS. 14A and 14B illustrate a main extension axis of wiring boards. More specifically, FIGS. 14A and 14B are schematic plan views of main portions of the wiring boards according to the first illustrative example and the first variation thereof, respectively.

As illustrated in FIG. 14A, the wiring board 1 includes the wiring 40 (the wiring portion 20 and the conductor portion 30) extending in the direction P perpendicular to the longitudinal direction X of the base 10. The main extension axis S of the wiring board 1 may diagonally cross the longitudinal direction X of the base 10. For example, in this case, the angle ($\alpha$) of the direction P of the conductor portion 30 with respect to the direction (Sv) perpendicular to the main extension axis S needs to be smaller than the angle ($\beta$) between the direction P of the conductor portion 30 and the diagonal line, from the viewpoints described with reference to FIGS. 13A to 13C. In this way, even when a crack running in the direction perpendicular to the main extension axis S is caused in the conductor portion 30 on the wiring portion 20, the resistance of the wiring 40 is not increased by the crack.

As illustrated in FIG. 14B, the wiring board 1a includes the wiring 40 (the wiring portion 20 and the conductor portion 30) extending in the direction P diagonally crossing the longitudinal direction X of the base 10. In this case, too, the main extension axis S of the wiring board 1a may diagonally cross the longitudinal direction X of the base 10. In this case, from the viewpoints described with reference to FIGS. 10A to 11B, the main extension axis S is in the direction Q perpendicular to the direction P of the wiring 40. In this way, even when a crack running in the direction P perpendicular to the main extension axis S is caused in the conductor portion 30 on the wiring portion 20, the resistance of the wiring 40 is not increased by the crack.

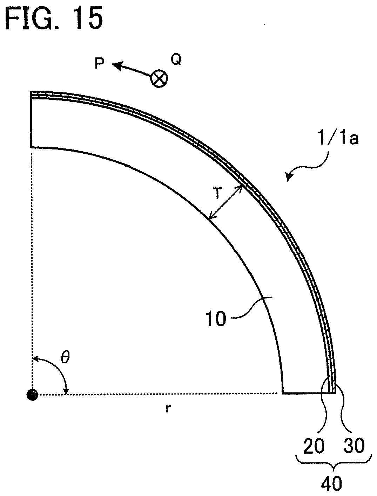

In addition, the wiring boards 1 and 1a could be extended in the direction P in which the wiring 40 extends. This will be described with reference to FIG. 15.

FIG. 15 illustrates an example of a bent wiring board. More specifically, FIG. 15 is a schematic sectional view of a main portion of a bent wiring board according to the first illustrative example or the first variation thereof.

In the case of the wiring board 1 or 1a, for example, as illustrated in FIG. 15, the wiring 40 (the wiring portion 20 and the conductor portion 30) extending in the direction P could be bent and extended in the direction P. In this case, the wiring 40 undergoes tensile stress by the extension. Thus, a crack running in the direction Q could be caused in the conductor portion 30 of the wiring 40. If such a crack is caused, the path of the current flowing through the conductor portion 30 could be divided, and as a result, the resistance of the wiring 40 could be increased. To avoid this, the following conditions may be set on the bent wiring board 1 or 1a.

Namely, assuming that the thickness of the base 10 of the wiring board 1 or 1a bent as illustrated in FIG. 15 is T, the radius of curvature when the wiring board 1 or 1a is bent is r, and the central angle is $\theta$, distortion U of the wiring 40 on the base 10 is expressed by the following expression (13).

$$U = \{2\pi(r + T)\theta - 2\pi r\theta\}/2\pi r\theta = T/r \ ...(13)$$

Assuming that fracture strain of the conductor portion 30 is V, when U ≤ V, fracture of the conductor portion 30 is avoided. From this relationship U ≤ V and the above expression (13), fracture of the conductor portion 30 is avoided when a condition expressed by the following expression (14) is met.

$$T/r \leq V \Leftrightarrow T \leq rV \Leftrightarrow r \leq T/V \ ...(14)$$

When the wiring board 1 or 1a is bent in the direction P, it is preferable that the wiring board 1 or 1a be bent to satisfy the condition expressed by the above expression (14) or that the installation location of the wiring board 1 or 1a be determined to satisfy the condition expressed by the above expression (14). In other words, it is preferable that the wiring board 1 or 1a be designed to satisfy the condition expressed by the above expression (14) when the wiring board 1 or 1a is bent or installed.

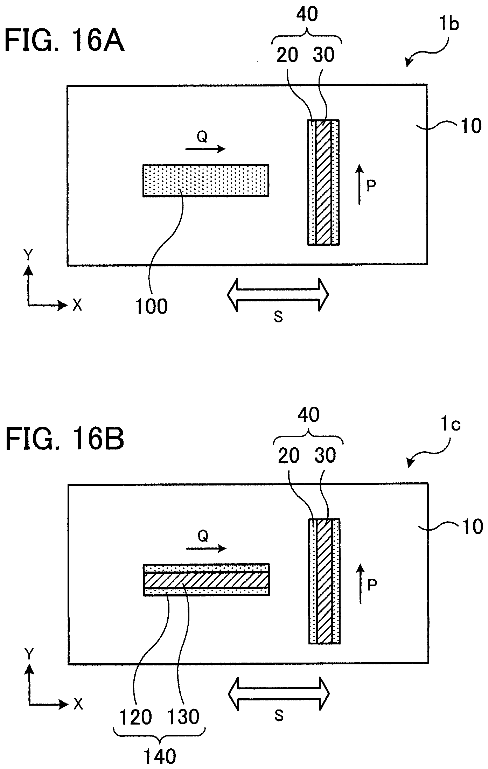

While the above wiring board 1 or 1a includes the wiring 40 extending in the direction P crossing the main extension axis S, the wiring board 1 or 1a may include another wiring extending in a direction different from the direction P. Structure examples of wiring boards each including a wiring extending in a different direction will be described with reference to FIGS. 16A and 16B.

FIGS. 16A and 16B illustrate structure examples of wiring boards according to the first illustrative example. More specifically, FIGS. 16A and 16B are schematic plan views of main portions of wiring boards according to second and third variations of the first illustrative example, respectively.

The wiring board 1b illustrated in FIG. 16A includes a wiring 100 extending in the direction Q in parallel with the main extension axis S, in addition to the wiring 40 extending in the direction P perpendicular to the main extension axis S on the base 10. The wiring 100 extending in the direction Q is made of conductive paste, which is made by including conductive fillers such as Ag fillers in an insulating binder such as silicone rubber, as with the wiring portion 20 of the wiring 40 extending in the direction P.

Regarding the wiring board 1b, the wiring 40 extending in the direction P includes the wiring portion 20 and the conductor portion 30 made of metal foil or the like on the wiring portion 20. Thus, the wiring 40 has low resistivity. Namely, even when the wiring board 1b is extended along the main extension axis S and a crack running in the direction P is caused, the increase of the resistance of the wiring 40 is prevented. Consequently, the wiring 40 representing stable characteristics against the extension along the main extension axis S is obtained.

In addition, regarding the wiring board 1b, the wiring 100 extending in the direction Q is made of conductive paste, and no conductor portion made of metal foil or the like is formed on the wiring 100. Thus, even when the wiring board 1b is extended along the main extension axis S, a crack is not caused easily. Accordingly, the increase of the resistance of the wiring 100 is prevented. Consequently, the wiring 100 representing stable characteristics against the extension along the main extension axis S is obtained.

The wiring board 1b including the wirings 40 and 100 represents stable characteristics against the extension along the main extension axis S. When the wiring board 1b is used for an electronic apparatus, the electronic apparatus stably operates even when the wiring board 1b is extended along the main extension axis S.

In FIG. 16A, the wirings 100 and 40 formed on the base 10 are separated from each other. However, these wirings 100 and 40 formed on the base 10 may be connected to each other.

The wiring board 1c illustrated in FIG. 16B differs from the wiring board 1b illustrated in FIG. 16A in that the wiring board 1c includes a wiring 140 on the base 10. The wiring 140 includes a wiring portion 120 extending in the direction Q in parallel with the main extension axis S and a conductor portion 130 on the wiring portion 120. The wiring portion 120 is made of conductive paste, which is made by including conductive fillers such as Ag fillers in an insulating binder such as silicone rubber, as with the wiring portion 20 extending in the direction P. The conductor portion 130 is made of metal foil or the like having lower resistivity than that of the wiring portion 120.

As described above, even when the wiring board 1c is extended along the main extension axis S, the wiring 40 extending in the direction P represents stable characteristics.

In addition, since the wiring 140 extending in the direction Q includes the wiring portion 120 and the conductor portion 130 formed thereon, the wiring 140 has low resistivity. However, when the wiring board 1c is extended along the main extension axis S, a crack running in the direction P could be caused in the conductor portion 130 of the wiring 140. If a crack is caused in the conductor portion 130, the resistance of the wiring 140 could be increased. However, unless such a crack is caused in the conductor portion 130, the resistance of the wiring 140 is maintained low.

By using the wirings 40 and 140, the wiring board 1c having low resistivity is obtained. By using the wiring board 1c for an electronic apparatus, a high-performance electronic apparatus is achieved.

In FIG. 16B, the wirings 140 and 40 formed on the base 10 are separated from each other. However, these wirings 140 and 40 formed on the base 10 may be connected to each other.

In addition, while FIGS. 16A and 16B each illustrate an example in which the direction P in which the wiring 40 extends is perpendicular to the main extension axis S, the direction P may have a certain angle with respect to the direction perpendicular to the main extension axis S, as in the example illustrated in FIGS. 13A to 13C. In addition, the direction Q in which the wirings 100 and 140 extend may also have a certain angle with respect to the main extension axis S or the direction perpendicular thereto. The main extension axis S need not match the longitudinal direction X of the base 10.

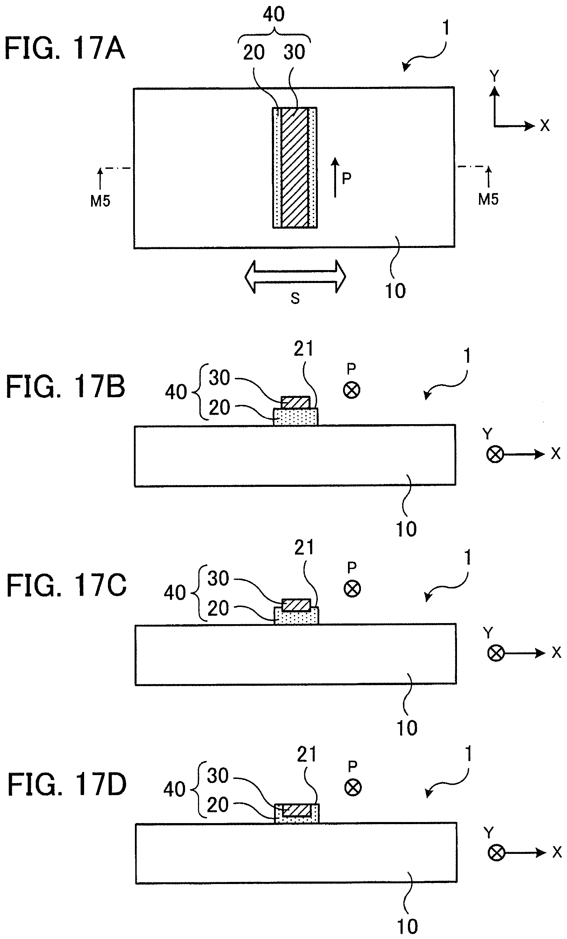

The wiring board 1 and the like may have wiring structures as illustrated in FIGS. 17A to 17D.

FIGS. 17A to 17D illustrate structures of the wiring of the wiring board according to the first illustrative example. More specifically, FIG. 17A is a schematic plan view of a main portion of the wiring board. Each of FIG. 17B to 17D is a schematic sectional view of the main portion of the wiring on the wiring board, taken along line M5-M5 in FIG. 17A.

As illustrated in FIG. 17A, the wiring board 1 includes the wiring 40 extending in the direction P on the base 10 (in the lateral direction Y perpendicular to the longitudinal direction X in FIG. 17A). The wiring 40 including the wiring portion 20 and the conductor portion 30 formed thereon may have any one of the structures illustrated in FIGS. 17B to 17D.

For example, as illustrated in FIG. 17B, the wiring 40 may be formed by forming the conductor portion 30 on an upper surface 21 of the wiring portion 20. Alternatively, for example, as illustrated in FIG. 17C, the wiring 40 may be formed by embedding a part of the conductor portion 30 into the upper surface 21 of the wiring portion 20. Alternatively, for example, as illustrated in FIG. 17D, the wiring 40 may be formed by embedding the entire conductor portion 30 into the wiring portion 20. The low-resistivity wiring 40 is formed by adopting any one of the structures illustrated in FIGS. 17B to 17D. Since the structures illustrated in FIGS. 17C and 17D improve the contact area and the bonding strength between the conductor portion 30 and the wiring portion 20, peeling of the conductor portion 30 from the wiring portion 20 is effectively prevented.

For example, the wiring 40 as illustrated in FIG. 17B may be formed by printing conductive paste serving as the wiring portion 20 on the base 10, allowing the conductive paste to cure, and laminating metal foil serving as the conductor portion 30 on the conductive paste. For example, the wirings 40 as illustrated in FIGS. 17C and 17D may be formed by printing conductive paste serving as the wiring portion 20 on the base 10 and laminating metal foil serving as the conductor portion 30 on the conductive paste before the conductive paste cures (or when the conductive paste partially cures).

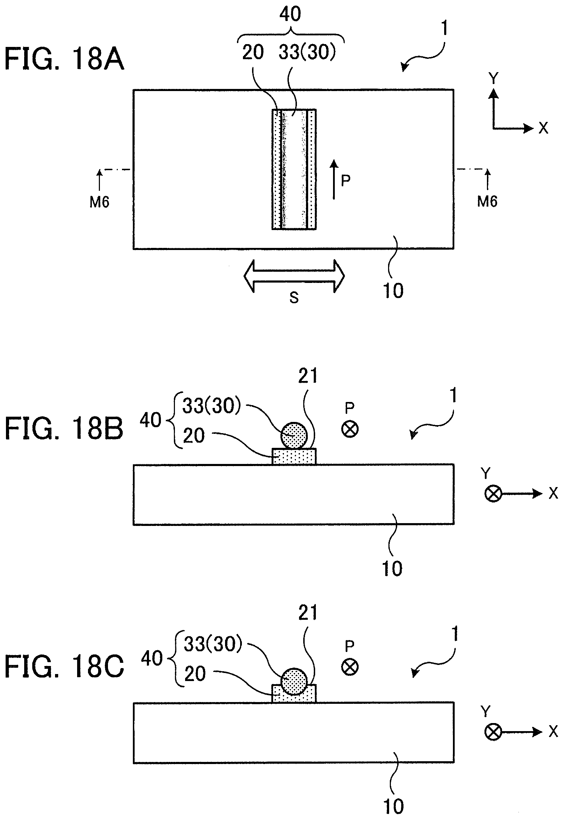

In addition, the wiring board 1 and the like may adopt wiring structures as illustrated in FIGS. 18A to 18C.

FIGS. 18A to 18C illustrate structures of the wiring of the wiring board according to the first illustrative example. More specifically, FIG. 18A is a schematic plan view of a main portion of the wiring. Each of FIGS. 18B and 18C is a schematic sectional view of the main portion of the wiring on the wiring board taken along line M6-M6 in FIG. 18A.

The wiring board 1 illustrated in FIG. 18A includes the wiring 40 extending in the direction P on the base 10 (in the lateral direction Y perpendicular to the longitudinal direction X in FIG. 18A). On the wiring portion 20 on the wiring 40, a member 33 such as a metal column or a metal thin line is formed as the conductor portion 30. The member 33 may be made of any one of various kinds of metal material such as Cu or Al.

The conductor portion 30 is formed on the wiring portion 20 made of conductive paste. As long as the conductor portion 30 is made of material having lower resistivity than that of the wiring portion 20, the member 33 such as a metal column or a metal thin line may be formed as the conductor portion 30. By forming the member 33 on the wiring portion 20, the increase of the resistance of the wiring 40 is prevented. In addition, even when the wiring board 1 is extended along the main extension axis S (in the longitudinal direction X of the base 10 in FIG. 18A), damage such as a crack running in the direction P perpendicular to the main extension axis S is not caused easily in the member 33. Thus, the resistance of the wiring 40 including the member 33 formed on the wiring portion 20 is maintained low.

For example, as illustrated in FIG. 18B, the member 33 such as a metal column or a metal thin line is formed on an upper surface 21 of the wiring portion 20. Alternatively, for example, as illustrated in FIG. 18C, a part of the member 33 may be embedded into the upper surface 21 of the wiring portion 20. The member 33 may be entirely embedded into the wiring portion 20. The low-resistivity wiring 40 is formed by adopting any one of the structures illustrated in FIGS. 18B and 18C. Since the structure illustrated in FIG. 18C improves the contact area and the bonding strength between the member 33 serving as the conductor portion 30 and the wiring portion 20, peeling of the member 33 from the wiring portion 20 is effectively prevented. In addition, the resistance of the wiring 40 is maintained low.

For example, the wiring 40 as illustrated in FIG. 18B may be formed by printing conductive paste serving as the wiring portion 20 on the base 10, allowing the conductive paste to cure, and laminating the member 33 such as a metal column or a metal thin line serving as the conductor portion 30 on the conductive paste. For example, the wiring 40 as illustrated in FIG. 18C may be formed by printing conductive paste serving as the wiring portion 20 on the base 10 and laminating the member 33 such as a metal column or a metal thin line serving as the conductor portion 30 on the conductive paste before the conductive paste cures or when the conductive paste partially cures.

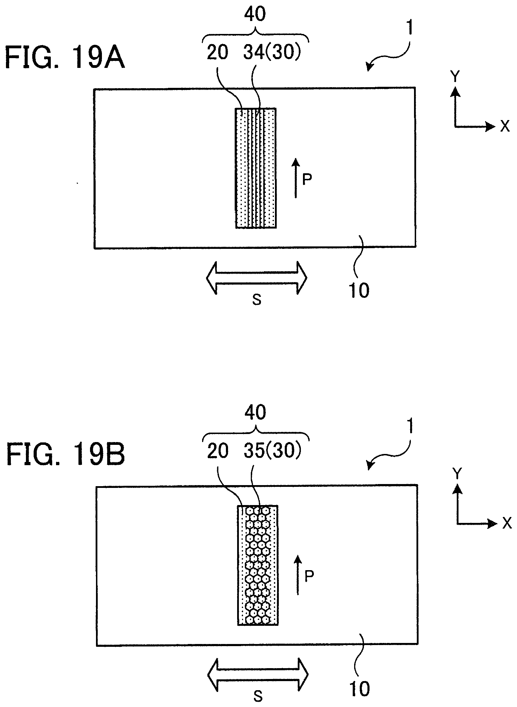

In addition, the wiring board 1 and the like may adopt wiring structures as illustrated in FIGS. 19A and 19B.

FIGS. 19A and 19B illustrate structures of the wiring of the wiring board according to the first illustrative example. Each of FIGS. 19A and 19B is a schematic plan view of a main portion of the wiring board.

The wiring board 1 illustrated in FIG. 19A includes the wiring 40 extending in the direction P on the base 10 (in the lateral direction Y perpendicular to the longitudinal direction X in FIG. 19A). On the wiring portion 20 on the wiring 40, at least one CNT 34 (a plurality of CNTs 34, for example) is formed as the conductor portion 30. The CNT 34 has high electron mobility, and by forming the CNT 34 on the wiring portion 20, the resistance of the wiring 40 is maintained low. In addition, even when the wiring board 1 is extended along the main extension axis S (in the longitudinal direction X of the base 10 in FIG. 19A), the CNT 34 is not easily damaged. Thus, the resistance of the wiring 40 including the CNT 34 on the wiring portion 20 is maintained low.

The wiring board 1 illustrated in FIG. 19B includes the wiring 40 extending in the direction P on the base 10 (in the lateral direction Y perpendicular to the longitudinal direction X in FIG. 19B). In addition, on the wiring portion 20 on the wiring 40, at least one layer of graphene 35 is formed as the conductor portion 30. Any one of various shapes such as a graphene sheet, graphene and nanoribbons may be used for the graphene 35. The graphene 35 has high electron mobility, and by forming the graphene 35 on the wiring portion 20, the resistance of the wiring 40 is maintained low. In addition, even when the wiring board 1 is extended along the main extension axis S (in the longitudinal direction X of the base 10 in FIG. 19B), the graphene 35 is not easily damaged. Thus, the resistance of the wiring 40 including the graphene 35 on the wiring portion 20 is maintained low.

While the CNT 34 and the graphene 35 have been used as examples, another carbon material having high electron mobility may alternatively be used as the conductor portion 30 formed on the wiring portion 20. A composite material made of carbon and metal materials, such as a carbon material including a metal material, may be used as the conductor portion 30.

For example, each of the wirings 40 as illustrated in FIGS. 19A and 19B may be formed by printing conductive paste serving as the wiring portion 20 on the base 10 and laminating the CNT 34 or the graphene 35 serving as the conductor portion 30 on the conductive paste before or after the conductive paste cures.

The wiring structures as illustrated in FIGS. 17A to 19B may also be applied to the wiring boards 1a to 1c. Namely, these wiring structures may be applied not only to the wirings 40 extending in the direction P but also to the wiring 140 extending in the direction Q perpendicular to the direction P as illustrated in FIG. 16B.

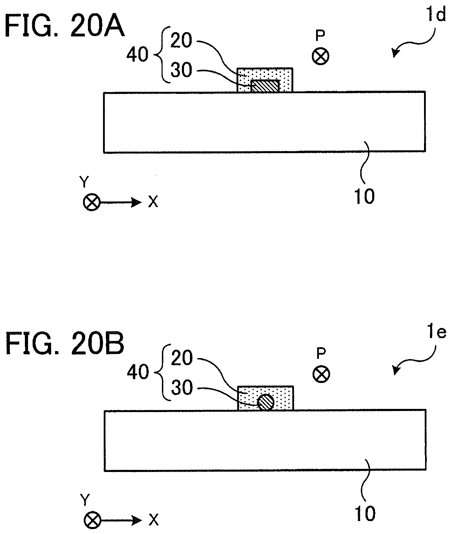

The wiring board 1 and the like may adopt wiring structures as illustrated in FIGS. 20A and 20B.

FIGS. 20A and 20B illustrate structures of wirings of wiring boards according to fourth and fifth variations of the first illustrative example. FIGS. 20A and 20B are schematic sectional views of main portions of wiring boards according to fourth and fifth variations, respectively.

The wiring board 1d illustrated in FIG. 20A includes a wiring 40 on a base 10. The wiring 40 includes a conductor portion 30 made of metal foil, graphene, etc. and a wiring portion 20 made of conductive paste. The wiring portion 20 covers the conductor portion 30.

In addition, the wiring board 1e illustrated in FIG. 20B includes a wiring 40 on a base 10. The wiring 40 includes a conductor portion 30 formed as a metal column, a metal thin line, CNT, etc. and a wiring portion 20 made of conductive paste. The wiring portion 20 covers the conductor portion 30.

As illustrated in FIGS. 20A and 20B, the wiring 40 may be formed by the conductor portion 30 and the wiring portion 20 covering the conductor portion 30. By covering the conductor portion 30 with the wiring portion 20, the conductor portion 30 is not easily peeled from the base 10. In addition, even when the base 10 is extended, a crack is not easily caused in the conductor portion 30. Thus, the resistance of the wiring 40 is maintained low.

For example, each of the wirings 40 as illustrated in FIGS. 20A and 20B may be formed by forming metal foil, a metal column, a metal thin line, a CNT, graphene, or the like serving as the conductor portion 30 on the base 10, printing conductive paste serving as the wiring portion 20 in such a manner that the conductive paste covers the conductor portion 30, and allowing the conductor portion 30 and the wiring portion 20 to cure.

Next, a second illustrative example will be described.

Because of its extensibility, a wiring board is installed on a curved surface or is suitably adopted by an electronic apparatus that is bent or extended by external force. Examples of such an electronic apparatus include beacons, which are wireless communication devices that transmit predetermined information (electronic signals), and wearable terminals worn by users when used.

For example, as a service provided by a beacon, there is a service in which a beacon installed on a certain location transmits predetermined information to a terminal such as a smartphone or a tablet, to provide the terminal with location information (location information or location-related information). Such information transmitted by beacons is used at facilities such as underground shopping malls where a global positioning system (GPS) is not available, so that users are provided with current locations or are guided to their destinations. In this case, it is preferable that beacons be installable on various places regardless of flat surfaces and curved surfaces. For example, it is preferable that beacons be installable on outer surfaces of devices (lighting equipment, etc.) in facilities or inside these devices.

In addition, as a service provided by a beacon, there is a service in which location information of a terminal is acquired by using information transmitted from a beacon included in the terminal. For example, when a user of a terminal including a beacon is lost or wanders around, searching for the user is performed by using information about the user transmitted by the beacon. In this case, it is preferable that the terminal be a wearable terminal in the shape of a wristwatch, a wristband, a ring, or the like that is worn on the user's body, that does not hinder the user's movement, and that is not lost easily.

A wiring board having extensibility is suitable for a beacon or a wearable terminal installable on various places as described above. In the second illustrative example, a beacon will be described as an example of an electronic apparatus in which a wiring board having extensibility is adopted.

First, for comparison, a beacon according to a fifth example will be described.

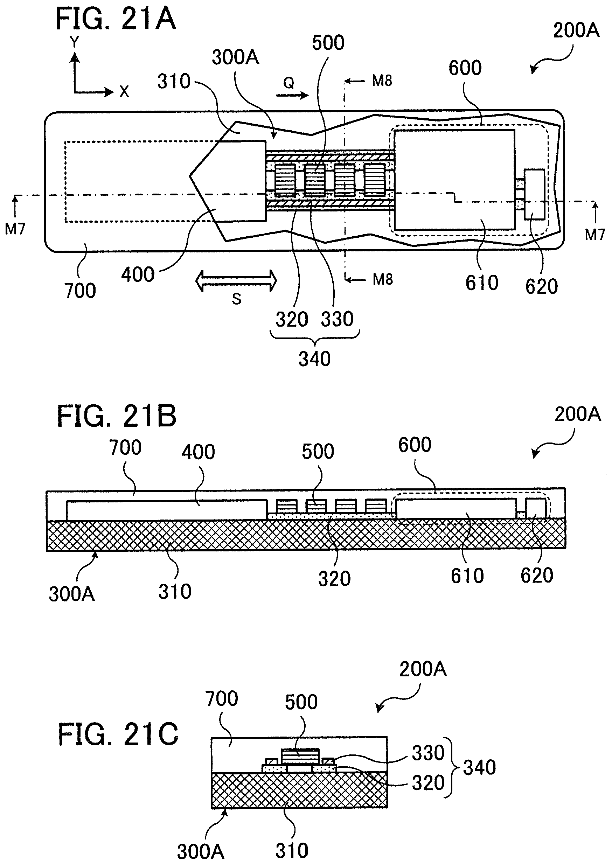

FIGS. 21A to 21C illustrate a structure example of a beacon according to a fifth example. More specifically, FIG. 21A is a schematic plan view of a main portion of a beacon according to a fifth example. FIG. 21B is a schematic sectional view taken along line M7-M7 in FIG. 21A. FIG. 21C is a schematic sectional view taken along line M8-M8 in FIG. 21A. In FIG. 21A, for convenience, a part of an exterior material is not illustrated.

The beacon 200A illustrated in FIGS. 21A to 21C includes: a wiring board 300A having extensibility; a power supply portion 400, at least one electricity storage element 500, and a load portion 600, which are mounted on the wiring board 300A; and an exterior material 700 covering these components.

For the wiring board 300A of the beacon 200A, the technique corresponding to the wiring board 1C as described with reference to FIGS. 4A and 4B has been adopted. The wiring board 300A includes a base 310 having extensibility (corresponding to the base 10 of the wiring board 1C), a pair of wiring portions 320 (each corresponding to the wiring portion 20 of the wiring board 1C) formed side by side on the base 310, and conductor portions 330 (each corresponding to the conductor portion 30 of the wiring board 1C) formed on the respective wiring portions 320.

An elastomer such as silicone rubber whose planar shape is substantially rectangular is used as the base 310. The base 310 has its longitudinal direction X in parallel with a main extension axis S of the wiring board 300A. Each of the wiring portions 320 is formed by printing conductive paste on the base 310. The conductive paste is obtained by including conductive fillers such as Ag particles in an insulating binder such as silicone rubber. On the wiring board 300A, each of the wiring portions 320 extends in a direction Q in parallel with the main extension axis S. On each of the wiring portions 320, a conductor portion 330 made of metal material or carbon material having lower resistivity than that of the wiring portions 320 is formed. A wiring portion 320 and a conductor portion 330 thereon form a wiring 340 (corresponding to the wiring 40 of the wiring board 1C) that serves as a part of the current paths of the wiring board 300A.

The power supply portion 400, the electricity storage element 500, and the load portion 600 are mounted on the wiring board 300A of the beacon 200A.

Any one of various kinds of power supply such as primary cells, secondary cells, or solar cells is used for the power supply portion 400. Among these power supplies, it is preferable that solar cells be used for the power supply portion 400, since solar cells are flexibly deformable in accordance with the installation site of the beacon 200A and no or little maintenance work such as replacement is needed. The power supply portion 400 is electrically connected to the pair of wirings 340 of the wiring board 300A.

Between the pair of wirings 340 connected to the power supply portion 400, at least one electricity storage element 500 is implemented. In FIG. 21A, as an example, four electricity storage elements 500 connected in parallel are illustrated between the pair of wirings 340. Capacitors such as chip capacitors are used as the electricity storage elements 500. The electricity storage elements 500 are implemented on the wiring portions 320 of the pair of wirings 340, as illustrated in FIG. 21C. The electricity storage elements 500 may be implemented on the conductor portions 330 of the pair of wirings 340.

The pair of wirings 340 connected to the electricity storage elements 500 is electrically connected to the load portion 600. The load portion 600 includes a control unit 610 and a wireless communication module 620. The control unit 610 includes various kinds of electronic component, such as semiconductor elements such as transistors, resistors, and capacitors, which are connected by wirings. The control unit 610 controls various kinds of operation, such as supplying a power supply to the wireless communication module 620 and transmitting information from the wireless communication module 620.

The exterior material 700 (a part of which is not illustrated in FIG. 21A) is formed on the wiring board 300A on which the power supply portion 400, the electricity storage elements 500, and the load portion 600 are mounted. The exterior material 700 covers the wirings 340, the power supply portion 400, the electricity storage elements 500, and the load portion 600. An elastomer such as silicone rubber is used as the exterior material 700, as with the base 310.

In the beacon 200A, electric charges discharged from the power supply portion 400 are transmitted to the electricity storage elements 500 via the wirings 340. The electric charges are temporarily accumulated in the electricity storage elements 500. After a certain quantity of electric charges is accumulated, the electric charges are transmitted from the electricity storage elements 500 to the load portion 600 via the wirings 340. For example, the control unit 610 monitors the quantity of electric charges accumulated in the electricity storage elements 500. After the certain quantity of electric charges is accumulated, the control unit 610 supplies the electric charges from the electricity storage elements 500 to the wireless communication module 620. When receiving the electric charges, the wireless communication module 620 transmits predetermined information to the outside.

For example, the beacon 200A having the above structure is bent and attached to a curved surface of a device in a facility, bent and mounted inside a wearable terminal, or bent in accordance with deformation of a wearable terminal. Since the base 310, the wiring portions 320, and the exterior material 700 are each made of an elastomer such as silicone rubber, the beacon 200A may be bent as described above. In addition, for example, since components having flexibility such as solar cells are used for the power supply portion 400 and small electronic components are used for the electricity storage elements 500 and the load portion 600, the beacon 200A may be bent more easily.

For example, the beacon 200A is attached to a device in a facility or mounted on a wearable terminal (including a deformable wearable terminal) in such a manner that the direction in which the beacon 200A is bent and extended is in parallel with the main extension axis S, which is in parallel with the longitudinal direction X of the base 310.

The wirings 340, each including a wiring portion 320 and a conductor portion 330 formed thereon, are formed on the wiring board 300A of the beacon 200A. The wirings 340 of the beacon 200A extend in the direction Q in parallel with the main extension axis S (the longitudinal direction X of the base 310). An individual wiring 340 is formed by forming a wiring portion 320 made of conductive paste and forming a conductor portion 330, which is made of metal material or carbon material having lower resistivity than that of the wiring portion 320, on the wiring portion 320. In this way, the wirings 340 have lower resistance than that of the wirings 340 formed only by the wiring portions 320. As a result, the reduction of the voltage drop when a current flows through the wirings 340 is achieved (see the above description made with reference to FIGS. 3A to 4B, as needed).

However, the conductor portions 330, which are included in the wirings 340 of the beacon 200A and that extend in the direction Q in parallel with the main extension axis S, could hinder extension of the beacon 200A along the main extension axis S (FIGS. 4A and 4B and FIGS. 6A and 6B). Hindrance of the extension of the beacon 200A by the conductor portions 330 could limit the installation site of the beacon 200A or the kind of wearable terminal on which the beacon 200A is mounted.

In addition, when the conductor portions 330 extending in the direction Q in parallel with the main extension axis S is extended along the main extension axis S, a crack running in a direction perpendicular to the main extension axis S could be caused in any one of the conductor portions 330 (see the above description made with reference to FIGS. 4A and 4B and FIGS. 8A to 9B, as needed). The crack in a conductor portion 330 could increase the resistance of the corresponding wiring 340. When the crack increases the resistance of the wiring 340, if the voltage drop when a current flows through the wiring 340 increases, the load portion 600 suffers from a lack of power. As a result, the wireless communication module 620 could not stably operate or fail to operate at all. Thus, when the beacon 200A is extended, the characteristics of the wiring board 300A could change, and as a result, the characteristics of the beacon 200A could change.

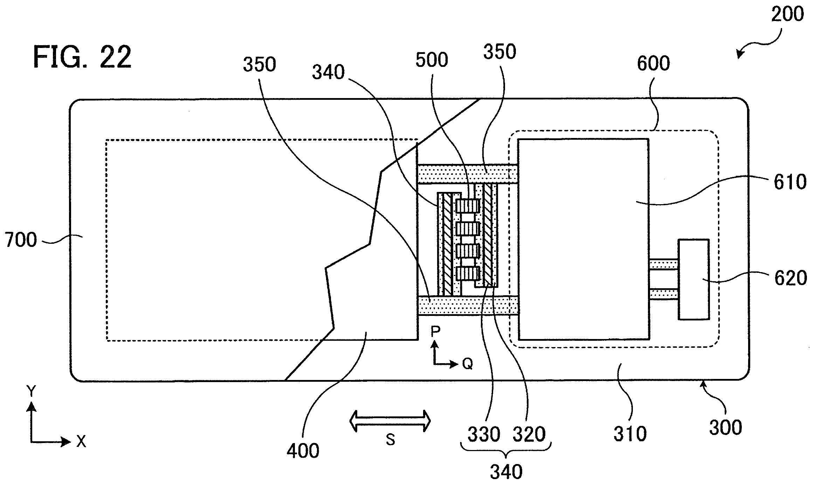

FIG. 22 illustrates a structure example of a beacon according to a second illustrative example. More specifically, FIG. 22 is a schematic plan view of a main portion of a beacon. In FIG. 22, for convenience, a part of an exterior material is not illustrated.

A beacon 200 illustrated in FIG. 22 includes: a wiring board 300 having extensibility; a power supply portion 400, at least one electricity storage element 500, and a load portion 600, which are mounted on the wiring board 300; and an exterior material 700 covering these components.

For the wiring board 300 of the beacon 200, the technique corresponding to the wiring board 1 as described with reference to FIGS. 5A and 5B is adopted. The wiring board 300 includes a base 310 having extensibility (corresponding to the base 10 of the wiring board 1), a pair of wiring portions 320 (each corresponding to the wiring portion 20 of the wiring board 1) formed side by side on the base 310, and conductor portions 330 (each corresponding to the conductor portion 30 of the wiring board 1) formed on the respective wiring portions 320. The base 310 of the wiring board 300 of the beacon 200 has a longitudinal direction X in parallel with a main extension axis S, and the wiring portions 320 and the conductor portions 330 are formed on the base 310 to extend in a direction P perpendicular to the main extension axis S. A wiring portion 320 and a conductor portions 330 thereon form a wiring 340 (corresponding to the wiring 40 of the wiring board 1) that serves as a part of the current paths of the wiring board 300.

The wiring board 300 further includes a pair of wiring portions (wirings) 350 that electrically connects the power supply portion 400 such as solar cells and the load portion 600 including a control unit 610 and a wireless communication module 620. The wirings 350 are formed on the base 310 to extend in a direction Q in parallel with the main extension axis S. One of the wirings 350 extending in the direction Q is connected to one of the wirings 340 extending in the direction P, and the other wiring 350 extending in the direction Q is connected to the other wiring 340 extending in the direction P.

At least one electricity storage element 500 such as a chip capacitor is mounted between the wirings 340 extending in the direction P of the wiring board 300. In FIG. 22, as an example, four electricity storage elements 500 connected in parallel are illustrated between the pair of wirings 340.

The beacon 200 differs from the beacon 200A including the wiring board 300A as illustrated in FIGS. 21A to 21C in that the beacon 200 includes the wiring board 300 as described above. The beacon 200 may include the same power supply portion 400, electricity storage elements 500, load portion 600 (the control unit 610 and the wireless communication module 620), and exterior material 700 as those of the above beacon 200A.

In the beacon 200, electric charges discharged from the power supply portion 400 are transmitted to the electricity storage elements 500 via the wirings 340 and 350. The electric charges are temporarily accumulated in the electricity storage elements 500. After a certain quantity of electric charges is accumulated, the electric charges are transmitted from the electricity storage elements 500 to the load portion 600 via the wirings 340 and 350. For example, the control unit 610 monitors the quantity of electric charges accumulated in the electricity storage elements 500. After the certain quantity of electric charges is accumulated, the control unit 610 supplies the electric charges from the electricity storage elements 500 to the wireless communication module 620. When receiving the electric charges, the wireless communication module 620 transmits predetermined information to the outside.

For example, the beacon 200 having the above structure is bent and attached to a curved surface of a device in a facility, bent and mounted inside a wearable terminal, or bent in accordance with deformation of a wearable terminal. For example, the beacon 200 is attached to a device in a facility or mounted on a wearable terminal (including a deformable wearable terminal) in such a manner that the direction in which the beacon 200 is bent and extended is in parallel with the main extension axis S, which is in parallel with the longitudinal direction X of the base 310.

Each of the wirings 340 of the beacon 200 is formed by forming a wiring portion 320 extending in the direction P perpendicular to the main extension axis S and a conductor portion 330 extending in the same direction P on the wiring portion 320. In addition to the wirings 340 in the direction P, the beacon 200 includes the wirings 350 extending in the direction Q in parallel with the main extension axis S. The conductor portions 330 are not formed on the wirings 350 extending in the direction Q. Extending the conductor portions 330 in the direction P perpendicular to the main extension axis S less hinders the extension of the base 310 than extending the conductor portions 330 in the direction Q in parallel with the main extension axis S (see the above description made with reference to FIG. 6A to FIG. 7B, as needed). Thus, the conductor portions 330 of the beacon 200 less hinders the extension of the base 310.

Since the conductor portions 330 are formed on the wiring portions 320, the resistance of the wirings 340 is maintained low. The electricity storage elements 500 are connected to these wirings 340 having low resistance. Since the wirings 340 including the conductor portions 330 extend in the direction P perpendicular to the main extension axis S, even when the beacon 200 is extended along the main extension axis S, a crack that increases the resistance of the wirings 340 is not easily caused in any one of the conductor portions 330 (see the above description made with reference to FIGS. 10A to 11B, as needed). Thus, even when the beacon 200 is extended, change of the characteristics of the wiring board 300 is reduced. As a result, since increase of the voltage drop is reduced, change of the amount of power supplied to the load portion 600 is reduced. Namely, even when the beacon 200 is extended, since change of the characteristics of the wiring board 300 is reduced, change of the characteristics of the beacon 200 is reduced. Therefore, the beacon 200 stably operates.

In addition, since the electricity storage elements 500 of the beacon 200 are formed side by side in the direction P, the base 310 has a smaller size in its longitudinal direction X than that of the above beacon 200A including the electricity storage elements 500 formed side by side in the direction Q. Namely, the beacon 200 has a smaller size than the above beacon 200A. As a result, the beacon 200 may be installed and mounted on a more variety of devices or wearable terminals.

The electricity storage elements 500 of the beacon 200 may be arranged and connected differently from what is illustrated in FIG. 22.

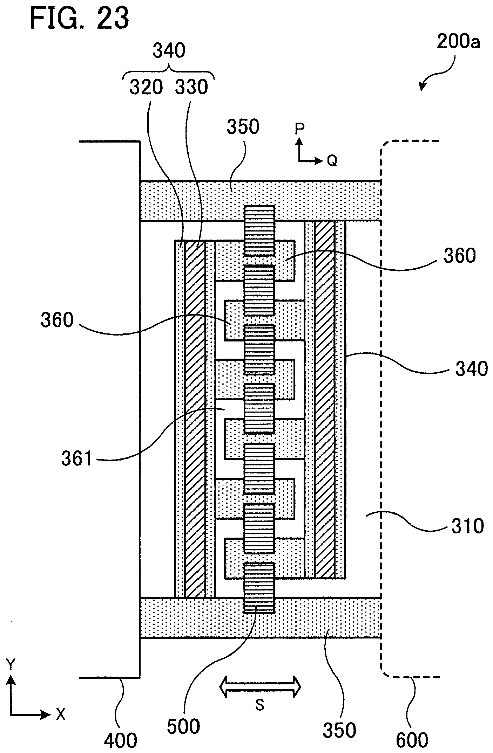

FIG. 23 illustrates a beacon according to a first variation of the second illustrative example. More specifically, FIG. 23 is a schematic plan view of a main portion of a beacon.

This beacon 200a illustrated in FIG. 23 includes a pair of wiring portions 320, each extending in a direction P perpendicular to a main extension axis S and a plurality of wiring portions (protruding wirings) 360 each protruding from one wiring portion 320 to the other wiring portion 320 (along a direction Q). The wiring portions 320 and the protruding wirings 360 are connected to each other. The protruding wirings 360 protruding from one wiring portion 320 are arranged to face the respective protruding wirings 360 protruding from the other wiring portion 320. One wiring portion 320 and the protruding wirings 360 connected thereto are spaced apart from the other wiring portion 320 and the protruding wirings 360 connected thereto with a gap 361, which is in the form of a crank course.

The protruding wirings 360 are formed by printing conductive paste on a base 310. For example, the protruding wirings 360 are printed on the base 310 simultaneously with the wiring portions 320 (and wirings 350) .

Conductor portions 330 are made of metal material or carbon material having lower resistivity than the wiring portions 320, and the conductor portions 330 are formed on the respective wiring portions 320. A wiring portion 320 and a conductor portion 330 thereon form a wiring 340 extending in the direction P.

For example, the conductor portions 330 are not formed on the wirings 350 that connect a power supply portion 400 and a load portion 600 and that extend in the direction Q nor on the protruding wirings 360 that protrude from the wirings 340.

The beacon 200a includes at least one electricity storage element 500 such as a chip capacitor (seven electricity storage elements 500 in FIG. 23 as an example). Two electricity storage elements 500 are each connected between protruding wirings 360 that face each other and that are arranged between the pair of wirings 340. Each one of the other electricity storage elements 500 is connected between a protruding wiring 360 and a wiring 350 that face each other.

For example, an individual electricity storage element 500 has a rectangular planar shape. An electricity storage element 500 having a rectangular planar shape is arranged and connected between protruding wirings 360 facing each other or between a protruding wiring 360 and a wiring 350 facing each other, in such a manner that the longitudinal direction of the electricity storage element 500 is in the direction P, as illustrated in FIG. 23. If the electricity storage elements 500 are arranged in this way, even when the beacon 200a is bent and extended along the main extension axis S, the extension is not hindered by the electricity storage elements 500 as much as it is by those having its longitudinal direction in the direction Q.

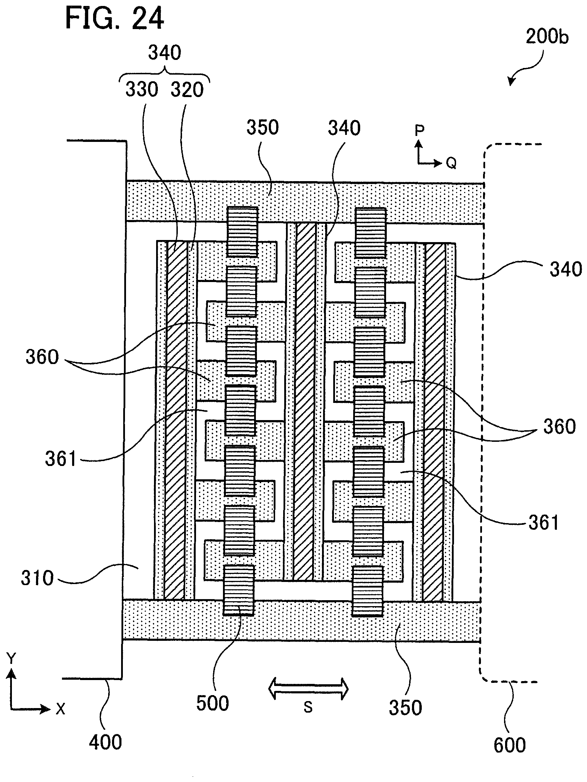

FIG. 24 is a beacon according to a second variation of the second illustrative example. More specifically, FIG. 24 is a schematic plan view of a main portion of a beacon.

This beacon 200b illustrated in FIG. 24 is obtained by forming two sets of the electricity storage elements 500 illustrated in FIG. 23 in parallel with each other.

Namely, in the beacon 200b, between a pair of wirings 340 that is connected to one wiring 350 extending in the direction Q and that extends in the direction P, another wiring 340 that is connected to the other wiring 350 extending in the direction Q and that extends in the direction P is formed. In addition, in the beacon 200b, between facing wirings 340, protruding wirings 360 are formed with a gap 361 in the form of a crank course, as in the above example in FIG. 23. In addition, an electricity storage element 500 is formed between protruding wirings 360 or between a protruding wiring 360 and a wiring 350.

With the beacon 200b having the above structure, the capacitance or the quantity of charges accumulated is increased by increasing the number of electricity storage elements 500. As a result, a sufficient amount of power supplied to the load portion 600 is ensured.

In addition, the electricity storage elements 500 are connected to the low-resistance wirings 340 including the conductor portions 330. In addition, since the wirings 340 extend in the direction P, even when the beacon 200b is extended along the main extension axis S, a crack is not easily caused in any one of the conductor portions 330. Thus, the resistance of the corresponding wiring 340 is not easily increased. Therefore, even when the number of electricity storage elements 500 is increased, the increase of the wiring length and the increase of the resistance thereby are prevented.

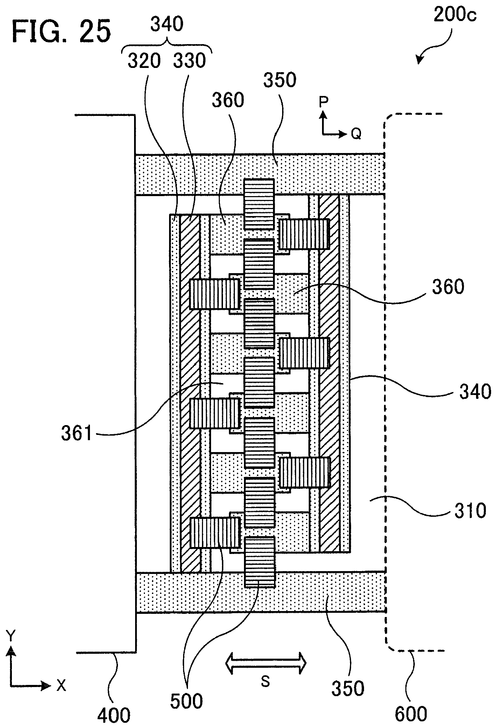

FIG. 25 illustrates a beacon according to a third variation of the second illustrative example. More specifically, FIG. 25 is a schematic plan view of a main portion of a beacon.

While this beacon 200c illustrated in FIG. 25 is similar to the beacon 200a illustrated in FIG. 23, these beacons are different in that the beacon 200c includes more electricity storage elements 500.

Namely, the beacon 200c includes additional electricity storage elements 500 each arranged and connected between a protruding wiring 360 protruding from one wiring 340 and the other wiring 340, in addition to the electricity storage elements 500 illustrated in FIG. 23.

With the beacon 200c having the above structure, by arranging electricity storage elements 500 more densely, more electricity storage elements 500 are arranged. Accordingly, since the capacitance or the quantity of charges accumulated is increased, a sufficient amount of power supplied to the load portion 600 is ensured.

While FIGS. 22 to 25 illustrate examples in which no conductor portion 330 is formed on the wirings 350 and the protruding wirings 360 extending in the direction Q, conductor portions 330 may be formed on these wirings 350 and protruding wirings 360. By forming the conductor portions 330, the resistance of the wirings 350 and the protruding wirings 360 is reduced. However, when the beacon is extended along the main extension axis S, a crack that increases the resistance is caused relatively easily in the conductor portions 330 formed on the wirings 350 and the protruding wirings 360. Thus, when such a crack is caused in a conductor portion 330, the characteristics of the wiring board 300 and the beacon 200, 200a, 200b, or 200c including the wiring board 300 could change. Unless a crack that increases the resistance of a wiring 350 and a protruding wiring 360 is caused in a conductor portion 330, the beacon 200, 200a, 200b, or 200c including the wiring board 300 including the low-resistivity wirings 350, protruding wirings 360, and wirings 340 represents good characteristics.

The conductor portions 330 of the wirings 340 (or of the wirings 340, wirings 350 and protruding wirings 360) may have any one of various planar shapes other than a rectangular planar shape.

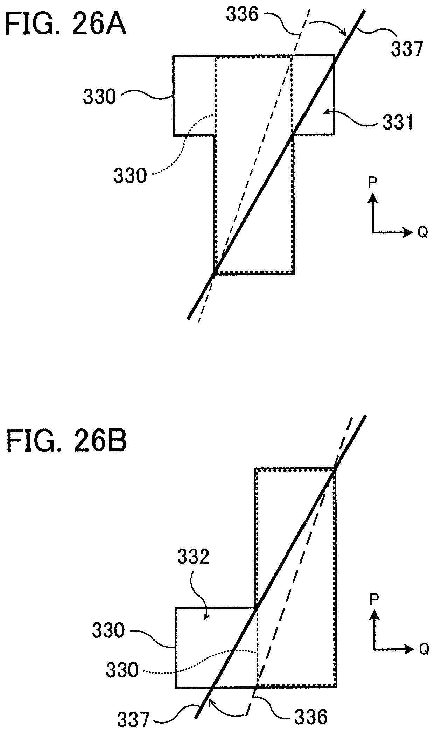

FIGS. 26A and 26B illustrate examples of a conductor portion in an embodiment of a wiring board according to the invention.

For example, as illustrated by a solid line in FIG. 26A, an end portion 331 of a conductor portion 330 extending in the direction P is widened in the direction Q perpendicular to the direction P so that the planar shape of the conductor portion 330 will be a T shape. In the case of the conductor portion 330 having a rectangular planar shape indicated by a dotted line in FIG. 26A, when a crack is caused in a location as illustrated by a chained line 336 (corresponding to a diagonal line), the path of the current flowing through the conductor portion 330 in the direction P is divided by the crack. As a result, the resistance of the corresponding wiring 340 including the conductor portion 330 is increased. In contrast, in the case of the conductor portion 330 whose planar shape is a T shape as indicated by the solid line in FIG. 26A, unless a crack is caused in a location illustrated by a thick solid line 337 and the path of the current flowing through the conductor portion 330 in the direction P is divided, the resistance of the corresponding wiring 340 including the conductor portion 330 is not increased. If the planar shape of the conductor portion 330 is formed to have a T shape, the range of the direction of the crack that does not increase the resistance of the corresponding wiring 340 is more widened, the range of the direction (angle) in which the corresponding wiring 340 extends is more widened, or the range of the main extension axis S is more widened, compared with the conductor portion 330 having a rectangular planar shape.

For example, as illustrated by a solid line in FIG. 26B, an end portion 332 of a conductor portion 330 extending in the direction P may be widened in the direction Q perpendicular to the direction P so that the planar shape of the conductor portion 330 will be an L shape. Namely, in the case of the conductor portion 330 having a rectangular planar shape as illustrated by a dotted line in FIG. 26B, when a crack is caused in a location as illustrated by a chained line 336 (corresponding to a diagonal line), the path of the current flowing through the conductor portion 330 is divided. As a result, the resistance of the corresponding wiring 340 including the conductor portion 330 is increased. In contrast, in the case of the conductor portion 330 whose planar shape is an L shape as indicated by a solid line in FIG. 26B, unless a crack is caused in a location as illustrated by a thick solid line 337 and the path of the current flowing through the conductor portion 330 is divided, the resistance of the wiring 340 is not increased. If the planar shape of the conductor portion 330 is formed to have an L shape, the range of the direction of the crack that does not increase the resistance of the corresponding wiring 340 is more widened, the range of the direction in which the corresponding wiring 340 extends is more widened, or the range of the main extension axis S is more widened, compared with the conductor portion 330 having a rectangular planar shape.

While the above description has been made with examples in which the planar shape of a conductor portion 330 is T or L shape, the same advantageous effects are obtained by forming the planar shape to be Japanese katakana character "e," which looks similar to the English letter "H" rotated by 90 degrees, or Japanese katakana character "ko," which looks similar to a square without the left side.

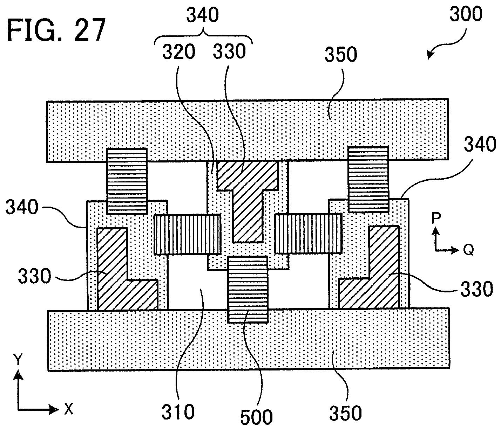

FIG. 27 illustrates an embodiment of a wiring board according to the invention. More specifically, FIG. 27 is a schematic plan view of a main portion of a wiring board according to the embodiment.

FIG. 27 illustrates an embodiment of a wiring board 300 including wirings 340 each including a wiring portion 320 and a conductor portion 330 as illustrated in FIG. 26A or 26B on the wiring portion 320. An individual wiring 340 is formed by forming a conductor portion 330 whose planar shape is a T shape or an L shape on the corresponding wiring portion 320 connected to a wiring 350. For example, an electricity storage element 500 is arranged and connected between wirings 340 or between a wiring 340 and a wiring 350. A beacon may be formed by using the wiring board 300 having this structure.

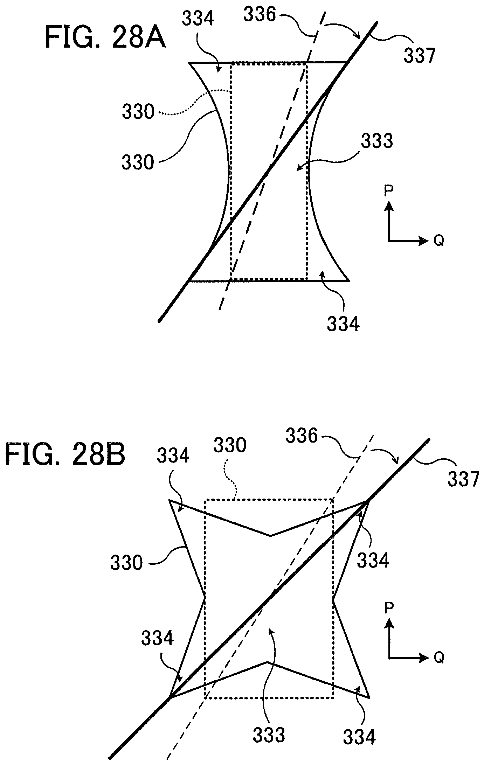

FIGS. 28A and 28B illustrate examples of a conductor portion according to the embodiment.

For example, a conductor portion 330 extending in the direction P is formed to have a planar shape as illustrated by a solid line in FIG. 28A. In FIG. 28A, the width of the conductor portion 330 gradually increases from its center portion 333 towards its two end portions 334 in the direction P. In other words, the conductor portion 330 extending in the direction P is formed to have a planar shape so that the width of the conductor portion 330 gradually decreases from the two end portions 334 towards the center portion 333.

With the conductor portion 330 having this planar shape, too, the same advantageous effects as described above are obtained. In the case of the conductor portion 330 having a rectangular planar shape indicated by a dotted line in FIG. 28A, if a crack is caused in a location indicated by a chained line 336, the resistance of the corresponding wiring 340 is increased. However, in the case of the conductor portion 330 having the widened planar shape, the direction of a crack that does not increase the resistance of the corresponding wiring 340 is widened to a location indicated by a thick solid line 337. In addition, for example, the range of the direction in which the corresponding wiring 340 extends is more widened, and the range of the main extension axis S is more widened, compared with the conductor portion 330 having a rectangular planar shape. In addition, by gradually increasing the width of the conductor portion 330 from the center portion 333 to the two end portions 334 so that the sides near the center portion 333 in the direction Q are bent in a concave shape, formation of a flexion point and stress concentration at a flexion point are prevented. Thus, occurrence of a crack is prevented. In addition, in the case of the conductor portion 330 indicated by a solid line in FIG. 28A, space for arranging electricity storage elements 500 is ensured beside the center portion 333 in the direction Q.

In addition, for example, the conductor portion 330 may be formed to have a planar shape as indicated by a solid line in FIG. 28B. In FIG. 28B, the width of the conductor portion 330 gradually increases from the center portion 333 towards its two end portions 334 in the direction P. In addition, the width of the conductor portion 330 gradually increases from the center portion 333 towards its two end portions 334 in the direction Q. In other words, the conductor portion 330 is formed to have a planar shape so that the width of the conductor portion 330 gradually decreases from the end portions 334 in the directions P and Q towards the center portion 333.

With this conductor portion 330, too, the same advantageous effects as described above are obtained. In the case of the conductor portion 330 indicated by a dotted line in FIG. 28B, if a crack is caused in a location indicated by a chained line 336, the resistance of the corresponding wiring 340 is increased. However, in the case of the conductor portion 330 having the widened planar shape, the direction of a crack that does not increase the resistance of the corresponding wiring 340 is widened to a location indicated by a thick solid line 337. In addition, for example, the range of the direction in which the corresponding wiring 340 extends is more widened, and the range of the main extension axis S is more widened, compared with the conductor portion 330 indicated by the dotted line in FIG. 28B. In addition, in the case of the conductor portion 330 indicated by the solid line in FIG. 28B, space for arranging electricity storage elements 500 is ensured beside the center portion 333 in the directions P and Q. As in the example in FIG. 28A, by gradually increasing the width of the conductor portion 330 from the center portion 333 to the end portions 334 in the directions P and Q so that the sides near the center portion 333 in the directions P and Q are bent in a concave shape and so that a flexion point is not formed, stress concentration is prevented. Thus, occurrence of a crack is prevented.

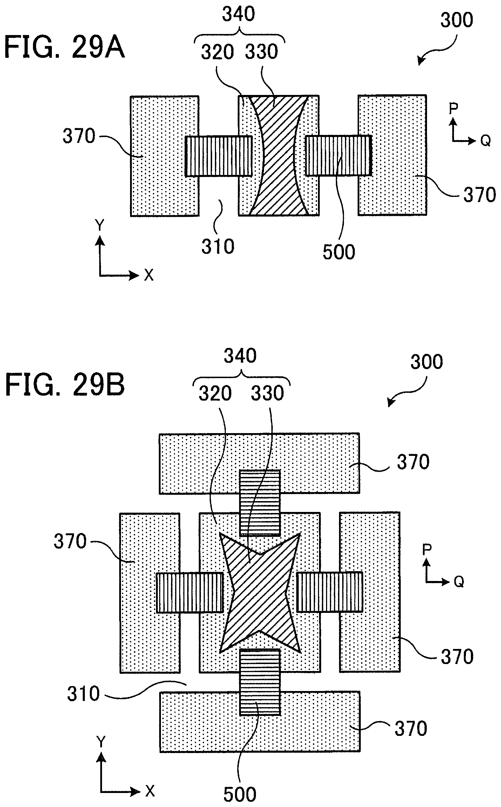

FIGS. 29A and 29B illustrate other embodiments of the wiring board according to the invention. More specifically, FIGS. 29A and 29B are schematic plan views of main portions of the wiring board according to the embodiment.

FIG. 29A is an example of the wiring board 300 including a wiring 340 including a wiring portion 320 and a conductor portion 330 as illustrated in FIG. 28A on the wiring portion 320. Two areas are ensured on the wiring portion 320 beside the conductor portion 330 in the direction Q, and two electricity storage elements 500 are connected to the wiring portion 320 on the respective areas. Each of the two electricity storage elements 500 is connected to another wiring 370. A beacon may be formed by using the wiring board 300 having this structure.

FIG. 29B illustrates an example of the wiring board 300 including a wiring 340 including a wiring portion 320 and a conductor portion 330 as illustrated in FIG. 28B on the wiring portion 320. Four areas are ensured on the wiring portion 320 beside the conductor portion 330 in the directions P and Q, and four electricity storage elements 500 are connected to the wiring portion 320 on the respective areas. Each of the four electricity storage elements 500 is connected to another wiring 370. A beacon may be formed by using the wiring board 300 having this structure.

A wiring board may be formed by mounting one or two of the above power supply portion 400, electricity storage elements 500, and load portion 600 on the base 310. For example, a wiring board may be formed by mounting at least one electricity storage element 500 on the base 310, without mounting the power supply portion 400 and the load portion 600.

The above beacons 200, 200a, 200b, 200c, etc. may be installed in or mounted on various kinds of electronic apparatus.

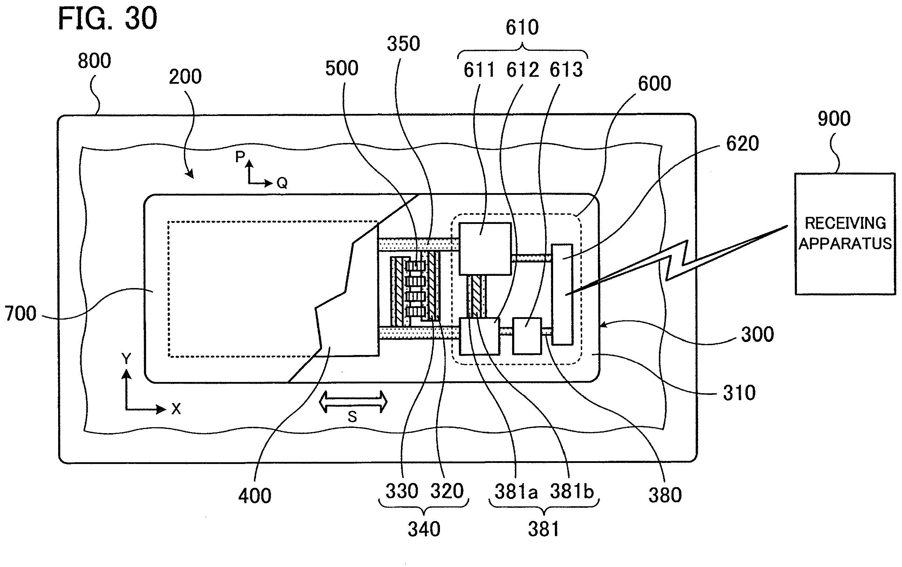

FIG. 30 illustrates an example of an electronic apparatus.

The beacon 200 as illustrated in FIG. 22 will be described as an example of the beacon. For example, the beacon 200 may be installed in a lighting equipment or mounted on a wearable terminal. FIG. 30 schematically illustrates how the beacon 200 is installed in or mounted on an electronic apparatus 800 such as a lighting equipment or a wearable terminal. The beacon 200 may be first extended in accordance with deformation of the electronic apparatus 800 and next installed in or mounted on the electronic apparatus 800. However, for convenience, FIG. 30 illustrates the beacon 200 that has not been extended yet.

The beacon 200 illustrated in FIG. 30 includes: a wiring board 300 having extensibility; and a power supply portion 400, electricity storage elements 500, and a load portion 600 mounted on the wiring board 300. For example, the base 310 of the wiring board 300 of the beacon 200 has a longitudinal direction X in parallel with a main extension axis S. The wiring board 300 includes wirings 340, each of which includes a wiring portion 320 and a conductor portion 330 formed thereon and extends in a direction P, and wirings 350, each of which extends in a direction Q perpendicular to the direction P. A plurality of (four, for example) electricity storage elements 500 are connected to the wirings 340 extending in the direction P. The load portion 600 includes: a control unit 610 including electronic components 611 to 613; and a wireless communication module 620. The wiring board 300 further includes a wiring 380 on which the electronic components 611 to 613 and the wireless communication module 620 of the load portion 600 are implemented. A part of the wiring 380, for example, a wiring 381 connecting the electronic components 611 and 612 and extending in the direction P, includes a wiring portion 381a and a conductor portion 381b formed thereon. The same structure as that of the wirings 340 is adopted for this part.

In the beacon 200, electric charges discharged from the power supply portion 400 are transmitted to the electricity storage elements 500 via the wirings 350 and 340. The electric charges are temporarily accumulated in the electricity storage elements 500. After a certain quantity of electric charges is accumulated, the electric charges are transmitted from the electricity storage elements 500 to the load portion 600 via the wirings 350 and 340. For example, the control unit 610 (the electronic components 611 to 613) monitors the quantity of electric charges accumulated in the electricity storage elements 500. After the certain quantity of electric charges is accumulated, the control unit 610 supplies the electric charges from the electricity storage elements 500 to the wireless communication module 620 via the wirings 340, 350, and 380. When receiving the electric charges, the wireless communication module 620 transmits predetermined information to the outside of the electronic apparatus 800.

The information transmitted from the beacon 200 of the electronic apparatus 800 is received by a receiving apparatus 900 (a terminal) outside the electronic apparatus 800 such as a smartphone, a tablet, a personal computer, or a wearable terminal. The receiving apparatus 900 uses the received information for various services. For example, the information is used for a location information service in which the receiving apparatus 900 is provided with its current location and is guided to its destination. As another example, the information is used for a monitoring service in which a source transmitting information about the beacon 200 is searched for.

The above description has been made by using, as an example, the electronic apparatus 800 including the beacon 200. However, an electronic apparatus using one of the other beacons 200a, 200b, 200c, etc. may be realized in the same way.

In addition, other than a beacon, the above wiring board having extensibility may be used for any one of various kinds of electronic apparatus such as computers (personal computers, supercomputers, servers, etc.), smartphones, mobile phones, tablet terminals, sensors, cameras, audio devices, measuring devices, inspection devices, and manufacturing devices. In this case, the wiring board may be used for connecting electronic components or connecting electronic apparatuses by using a connector, other than for mounting electronic components.

According to the disclosed technique, even when a base is extended in its longitudinal direction and a crack is caused thereby, the resistance is not changed by the crack. Namely, a wiring board representing stable characteristics is obtained. In addition, an electronic apparatus that includes the wiring board and that stably operates is obtained.

**Claims**

1. A wiring board comprising:

   a base (10, 310) that has extensibility;
   a first wiring portion (20, 320) that is formed on the base and extends in a first direction (P) crossing a longitudinal direction (X) of the base, in a plan view; and
   a first conductor portion (30, 330) that is formed on the first wiring portion and extends in the first direction (P), in the plan view;
   wherein:

   the first wiring portion (20, 320) is formed with a first width; and
   the first conductor portion (30, 330) is narrower than the first width; and
   **characterised in that** the first conductor portion (30, 330) has a wider end portion (331, 332, 334) in the first direction (P), in the plan view.

2. The wiring board according to claim 1,
   wherein the first wiring portion has extensibility, and wherein the first conductor portion has extensibility lower than that of the first wiring portion and has resistivity lower than that of the first wiring portion.

3. The wiring board according to claim 1 or 2,
   wherein the first wiring portion includes a binder (22) and a conductive filler (23) included in the binder, and
   wherein the first conductor portion includes metal material or carbon material (30, 33, 34, 35).

4. The wiring board according to any one of claims 1 to 3, wherein an angle ($\alpha$) between a lateral direction (Y) perpendicular to the longitudinal direction of the base and the first direction is smaller than an angle ($\beta$) between a diagonal line (31) of the first conductor portion and the first direction.

5. The wiring board according to claim 4, wherein the first conductor portion has a side bent in a concave shape.

6. The wiring board according to any one of claims 1 to 5, wherein a radius (r) of curvature of the base when the base is bent to extend in a lateral direction perpendicular to the longitudinal direction is set to be equal to or more than a value obtained by dividing a thickness (T) of the base by a fracture strain (V) of the first conductor portion.

7. The wiring board according to any one of claims 1 to 6, further comprising:

   a second wiring portion (320) that is formed on the base and extends in the first direction in parallel with the first wiring portion; and
   a second conductor portion (330) that is formed on the second wiring portion and extends in the first direction.

8. The wiring board according to claim 7, further comprising:

a third wiring portion (360) that is formed on the base and protrudes from the first wiring portion towards the second wiring portion; and
a fourth wiring portion (360) that is formed on the base and protrudes from the second wiring portion towards the first wiring portion in such a manner that the fourth wiring portion faces the third wiring portion.

9. The wiring board according to claim 7, further comprising an electricity storage element (500) that is mounted between the first wiring portion and the second wiring portion.

10. An electronic apparatus comprising: a wiring board (300) according to claim 1.

11. The electronic apparatus according to claim 10, wherein the wiring board further includes:

a second wiring portion (320, 350, 360) that is formed on the base, and
an electricity storage element (500) that is mounted between the first wiring portion and the second wiring portion on the wiring board.

12. The electronic apparatus according to claim 10, wherein the wiring board further includes:

a second wiring portion (320) that is formed on the base and extends in the first direction in parallel with the first wiring portion,
a second conductor portion (330) that is formed on the second wiring portion and extends in the first direction, and
an electricity storage element (500) that is mounted between the first wiring portion and the second wiring portion on the wiring board.

13. The electronic apparatus according to claim 12,
wherein the wiring board further includes:

a third wiring portion (360) that is formed on the base and protrudes from the first wiring portion towards the second wiring portion, and
a fourth wiring portion (360) that is formed on the base and extends from the second wiring portion towards the first wiring portion in such a manner that the fourth wiring portion faces the third wiring portion, and
wherein the electricity storage element is connected to the third wiring portion and the fourth wiring portion.

14. The electronic apparatus according to any one of claims 11 to 13, further comprising:

a power supply portion (400) that is mounted on the wiring board, that is electrically connected to the first wiring portion and the second wiring portion, and that supplies electric charges to the electricity storage element, and
a load portion (600) that is mounted on the wiring board, that is electrically connected to the first wiring portion and the second wiring portion, and that receives the electric charges from the electricity storage element.

**Patentansprüche**

1. Leiterplatte, umfassend
eine Basis (10, 310), die Erweiterbarkeit aufweist;
einen ersten Verdrahtungsabschnitt (20, 320), der auf der Basis gebildet ist und sich in einer ersten Richtung (P) erstreckt, die, in einer Draufsicht, eine Längsrichtung (X) der Basis quert; und
einen ersten Leiterabschnitt (30, 330), der auf dem ersten Verdrahtungsabschnitt gebildet ist und sich in der Draufsicht in der ersten Richtung (P) erstreckt;
wobei:

der erste Verdrahtungsabschnitt (20, 320) mit einer ersten Breite gebildet ist; und
der erste Leiterabschnitt (30, 330) schmaler als die erste Breite ist; und
**dadurch gekennzeichnet, dass** der erste Leiterabschnitt (30, 330) in der Draufsicht einen breiteren Endabschnitt (331, 332, 334) in der ersten Richtung (P) hat.

2. Leiterplatte nach Anspruch 1,
wobei der erste Verdrahtungsabschnitt Erweiterbarkeit aufweist; und
wobei der erste Leiterabschnitt Erweiterbarkeit aufweist, die geringer als jene des ersten Verdrahtungsabschnitts ist, und eine geringere Widerstandsfähigkeit als jene des ersten Verdrahtungsabschnitts aufweist.

3. Leiterplatte nach Anspruch 1 oder 2,
wobei der erste Verdrahtungsabschnitt ein Bindemittel (22) und ein leitendes Füllmittel (23), das im Bindemittel enthalten ist, enthält, und
wobei der erste Leiterabschnitt Metallmaterial oder Kohlenstoffmaterial (30, 33, 34, 35) enthält.

4. Leiterplatte nach einem der Ansprüche 1 bis 3, wobei ein Winkel ($\alpha$) zwischen einer seitlichen Richtung (Y) senkrecht zu der Längsrichtung der Basis und der ersten Richtung kleiner ist als ein Winkel ($\beta$) zwischen einer diagonalen Linie (31) des ersten Leiterabschnitts und der ersten Richtung.

5. Leiterplatte nach Anspruch 4, wobei der erste Leiterabschnitt eine Seitenbiegung in einer konkaven Form hat.

6. Leiterplatte nach einem der Ansprüche 1 bis 5, wobei ein Krümmungsradius (r) der Basis, wenn die Basis gebogen ist, um sich in einer seitlichen Richtung senkrecht zu der Längsrichtung zu erstrecken, eingestellt ist, gleich oder größer als ein Wert zu sein, der durch Dividieren einer Dicke (T) der Basis durch eine Bruchdehnung (V) des ersten Leiterabschnitts erhalten wird.

7. Leiterplatte nach einem der Ansprüche 1 bis 6, weiter umfassend:

einen zweiten Verdrahtungsabschnitt (320), der auf der Basis gebildet ist und sich in der ersten Richtung parallel zu dem ersten Verdrahtungsabschnitt erstreckt; und
einen zweiten Leiterabschnitt (330), der auf dem zweiten Verdrahtungsabschnitt gebildet ist und sich in der ersten Richtung erstreckt.

8. Leiterplatte nach Anspruch 7, weiter umfassend:

einen dritten Verdrahtungsabschnitt (360), der auf der Basis gebildet ist und von dem ersten Verdrahtungsabschnitt zu dem zweiten Verdrahtungsabschnitt vorsteht; und
einen vierten Verdrahtungsabschnitt (360), der auf der Basis gebildet ist und von dem zweiten Verdrahtungsabschnitt derart zu dem ersten Verdrahtungsabschnitt vorsteht, dass der vierte Verdrahtungsabschnitt dem dritten Verdrahtungsabschnitt zugewandt ist.

9. Leiterplatte nach Anspruch 7, weiter ein Elektrizitätsspeicherelement (500) umfassend, das zwischen dem ersten Verdrahtungsabschnitt und dem zweiten Verdrahtungsabschnitt montiert ist.

10. Elektronische Vorrichtung, umfassend:
eine Leiterplatte (300) nach Anspruch 1.

11. Elektronische Vorrichtung nach Anspruch 10, wobei die Leiterplatte weiter enthält:

einen zweiten Verdrahtungsabschnitt (320, 350, 360), der auf der Basis gebildet ist, und
ein Elektrizitätsspeicherelement (500), das zwischen dem ersten Verdrahtungsabschnitt und dem zweiten Verdrahtungsabschnitt auf der Leiterplatte montiert ist.

12. Elektronische Vorrichtung nach Anspruch 10, wobei die Leiterplatte weiter enthält:

einen zweiten Verdrahtungsabschnitt (320), der auf der Basis gebildet ist und sich parallel zu dem ersten Verdrahtungsabschnitt in der ersten Richtung erstreckt,
einen zweiten Leiterabschnitt (330), der auf dem zweiten Verdrahtungsabschnitt gebildet ist und sich in der ersten Richtung erstreckt, und
ein Elektrizitätsspeicherelement (500), das zwischen dem ersten Verdrahtungsabschnitt und dem zweiten Verdrahtungsabschnitt auf der Leiterplatte montiert ist.

13. Elektronische Vorrichtung nach Anspruch 12,

wobei die Leiterplatte weiter enthält:

einen dritten Verdrahtungsabschnitt (360), der auf der Basis gebildet ist und von dem ersten Verdrahtungsabschnitt zu dem zweiten Verdrahtungsabschnitt vorsteht; und

einen vierten Verdrahtungsabschnitt (360), der auf der Basis gebildet ist und sich von dem zweiten Verdrahtungsabschnitt derart zu dem ersten Verdrahtungsabschnitt erstreckt, dass der vierte Verdrahtungsabschnitt dem dritten Verdrahtungsabschnitt zugewandt ist, und

wobei das Elektrizitätsspeicherelement mit dem dritten Verdrahtungsabschnitt und dem vierten Verdrahtungsabschnitt verbunden ist.

14. Elektronische Vorrichtung nach einem der Ansprüche 11 bis 13, weiter umfassend:

einen Leistungsversorgungsabschnitt (400), der auf der Leiterplatte montiert ist, der elektrisch mit dem ersten Verdrahtungsabschnitt und dem zweiten Verdrahtungsabschnitt verbunden ist und der elektrische Ladungen zum Elektrizitätsspeicherelement leitet, und

einen Ladeabschnitt (600), der auf der Leiterplatte montiert ist, der elektrisch mit dem ersten Verdrahtungsabschnitt und dem zweiten Verdrahtungsabschnitt verbunden ist und der die elektrischen Ladungen von dem Elektrizitätsspeicherelement empfängt.

## Revendications

1. Carte de câblage comprenant :

une base (10, 310) qui a une certaine extensibilité ;
une première portion de câblage (20, 320) qui est formée sur la base et qui s'étend dans une première direction (P) croisant une direction longitudinale (X) de la base, dans une vue en plan ; et
une première portion formant conducteur (30, 330) qui est formée sur la première portion de câblage et qui s'étend dans la première direction (P), dans la vue en plan ;
dans laquelle :

la première portion de câblage (20, 320) est formée avec une première largeur ; et
la première portion formant conducteur (30, 330) est plus étroite que la première largeur ; et
**caractérisée en ce que** la première portion formant conducteur (30, 330) a une portion d'extrémité plus large (331, 332, 334) dans la première direction (P), dans la vue en plan.

2. Carte de câblage selon la revendication 1,
dans laquelle la première portion de câblage a une certaine extensibilité, et
dans laquelle la première portion formant conducteur a une extensibilité plus faible que celle de la première portion de câblage et a une résistivité plus faible que celle de la première portion de câblage.

3. Carte de câblage selon la revendication 1 ou 2,
dans laquelle la première portion de câblage inclut un liant (22) et un agent de remplissage conducteur (23) inclus dans le liant, et
dans laquelle la première portion formant conducteur inclut une matière métallique ou une matière carbonique (30, 33, 34, 35).

4. Carte de câblage selon l'une quelconque des revendications 1 à 3, dans laquelle un angle ($\alpha$) entre une direction latérale (Y) perpendiculaire à la direction longitudinale de la base et la première direction est plus petite qu'un angle ($\beta$) entre une ligne diagonale (31) de la première portion formant conducteur et la première direction.

5. Carte de câblage selon la revendication 4, dans laquelle la première portion formant conducteur a un côté plié de forme concave.

6. Carte de câblage selon l'une quelconque des revendications 1 à 5, dans laquelle un rayon (r) de courbure de la base quand la base est pliée pour s'étendre dans une direction latérale perpendiculaire à la direction longitudinale est fixé pour être égal ou supérieur à une valeur obtenue en divisant une épaisseur (T) de la base par une contrainte de fracture (V) de la première portion formant conducteur.

7. Carte de câblage selon l'une quelconque des revendications 1 à 6, comprenant en outre :

   une deuxième portion de câblage (320) qui est formée sur la base et qui s'étend dans la première direction parallèlement à la première portion de câblage ; et
   une seconde portion formant conducteur (330) qui est formée sur la deuxième portion de câblage et qui s'étend dans la première direction.

8. Carte de câblage selon la revendication 7, comprenant en outre :

   une troisième portion de câblage (360) qui est formée sur la base et qui dépasse de la première portion de câblage vers la deuxième portion de câblage ; et
   une quatrième portion de câblage (360) qui est formée sur la base et qui dépasse de la deuxième portion de câblage vers la première portion de câblage de telle sorte que la quatrième portion de câblage fait face à la troisième portion de câblage.

9. Carte de câblage selon la revendication 7, comprenant en outre un élément de stockage d'électricité (500) qui est monté entre la première portion de câblage et la deuxième portion de câblage.

10. Appareil électronique comprenant :
    une carte de câblage (300) selon la revendication 1.

11. Appareil électronique selon la revendication 10, dans lequel la carte de câblage inclut en outre :

    une deuxième portion de câblage (320, 350, 360) qui est formée sur la base, et
    un élément de stockage d'électricité (500) qui est monté entre la première portion de câblage et la deuxième portion de câblage sur la carte de câblage.

12. Appareil électronique selon la revendication 10, dans lequel la carte de câblage inclut en outre :

    une deuxième portion de câblage (320) qui est formée sur la base et qui s'étend dans la première direction parallèlement à la première portion de câblage,
    une seconde portion formant conducteur (330) qui est formée sur la deuxième portion de câblage et qui s'étend dans la première direction, et
    un élément de stockage d'électricité (500) qui est monté entre la première portion de câblage et la deuxième portion de câblage sur la carte de câblage.

13. Appareil électronique selon la revendication 12, dans lequel la carte de câblage inclut en outre :

    une troisième portion de câblage (360) qui est formée sur la base et qui dépasse de la première portion de câblage vers la deuxième portion de câblage, et
    une quatrième portion de câblage (360) qui est formée sur la base et qui s'étend à partir de la deuxième portion de câblage vers la première portion de câblage de telle sorte que la quatrième portion de câblage fait face à la troisième portion de câblage, et
    dans lequel l'élément de stockage d'électricité est relié à la troisième portion de câblage et à la quatrième portion de câblage.

14. Appareil électronique selon l'une quelconque des revendications 11 à 13, comprenant en outre :

    une portion d'alimentation en énergie (400) qui est montée sur la carte de câblage, qui est électriquement reliée à la première portion de câblage et à la deuxième portion de câblage et qui fournit des charges électriques à l'élément de stockage d'électricité, et
    une portion de charge (600) qui est montée sur la carte de câblage, qui est électriquement reliée à la première portion de câblage et à la deuxième portion de câblage, et qui reçoit les charges électriques en provenance de l'élément de stockage d'électricité.

FIG. 1A

M1→

1A

Q

10

20a

Y

X

M1→

S

FIG. 1B

Q

20a

1A

10

X

Y

FIG. 2

FIG. 3A

FIG. 3B

FIG. 4A

FIG. 4B

FIG. 5A

FIG. 5B

# FIG. 6A

# FIG. 6B

FIG. 7A

40
20  30

70

1

10

P

Y

X

S

FIG. 7B  70

Wc

10

We

F

30
40
20

L

## FIG. 8A

L

Wa

Wc

I ⋯→

Y

X

Q

S

20  30

40

## FIG. 8B

Ra

Rc

# FIG. 9A

# FIG. 9B

## FIG. 10A

## FIG. 10B

FIG. 11A

FIG. 11B

**FIG. 12A**

**FIG. 12B**

**FIG. 12C**

FIG. 13A

FIG. 13B

FIG. 13C

**FIG. 14A**

**FIG. 14B**

# FIG. 15

FIG. 16A

FIG. 16B

FIG. 17A

FIG. 17B

FIG. 17C

FIG. 17D

FIG. 18A

FIG. 18B

FIG. 18C

**FIG. 19A**

**FIG. 19B**

# FIG. 20A

# FIG. 20B

# FIG. 21A

# FIG. 21B

# FIG. 21C

FIG. 22

FIG. 23

FIG. 24

FIG. 25

FIG. 26A

FIG. 26B

FIG. 27

FIG. 28A

FIG. 28B

FIG. 29A

FIG. 29B

FIG. 30

**EP 3 277 062 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013187308 A
- EP 2924695 A1
- US 20140085837 A1
- US 20130303873 A1